# EUROPEAN PATENT SPECIFICATION

(11) **EP 4 036 174 B1**
(45) Date of publication and mention of the grant of the patent: **21.05.2025**
(21) Application number: 20867567.8
(22) Date of filing: 20.08.2020
(51) Int. Cl.: C08L 101/00, C01B 21/064, C08G 59/62, C08K 3/38, C08L 63/00, C09K 5/14, H01L 23/36

(54) **COMPOSITION FOR FORMING HEAT-CONDUCTING MATERIAL, HEAT-CONDUCTING MATERIAL, HEAT-CONDUCTING SHEET, AND DEVICE WITH HEAT-CONDUCTING LAYER**
ZUSAMMENSETZUNG ZUR FORMUNG VON WÄRMELEITENDEM MATERIAL, WÄRMELEITENDES MATERIAL, WÄRMELEITENDE FOLIE UND VORRICHTUNG MIT WÄRMELEITENDER SCHICHT
COMPOSITION POUR FORMATION DE MATÉRIAU DE CONDUCTION THERMIQUE, MATÉRIAU DE CONDUCTION THERMIQUE, FEUILLE DE CONDUCTION THERMIQUE, ET DISPOSITIF AVEC COUCHE DE CONDUCTION THERMIQUE

(30) Priority: 27.09.2019 JP 2019176932
(43) Date of publication of application: 03.08.2022
(73) Proprietor: FUJIFILM Corporation, Tokyo 106-8620 (JP)
(72) Inventor: KITAMURA Takuya, Ashigarakami-gun, Kanagawa 258-8577 (JP); KITAGAWA Hirotaka, Ashigarakami-gun, Kanagawa 258-8577 (JP)
(74) Representative: HGF
(86) International application number: PCT/JP2020/031419
(87) International publication number: WO 2021/059806

(56) References cited:
- EP-A1- 3 103 766
- JP-A- 2011 006 586
- JP-A- 2013 082 883
- JP-A- 2015 006 980
- JP-A- 2016 135 732
- JP-A- 2017 036 415
- JP-A- 2018 021 180

## Description

### BACKGROUND OF THE INVENTION

### 1. Field of the Invention

The present invention relates to a composition for forming a thermally conductive material, a thermally conductive material, a thermally conductive sheet, and a device with a thermally conductive layer.

### 2. Description of the Related Art

In recent years, a power semiconductor device used in various electrical machines such as a personal computer, a general household electric appliance, and an automobile has been rapidly miniaturized. With the miniaturization, it is difficult to control heat generated from the power semiconductor device having a high density.

In order to deal with such a problem, a thermally conductive material, which promotes heat dissipation from the power semiconductor device, is used.

For example, WO2016/093248A discloses an epoxy resin composition including an epoxy resin monomer, a curing agent, and a filler, in which the filler includes a first filler containing boron nitride particles having a particle diameter D50 of 20 µm or more and an average aspect ratio of 30 or less, and a second filler containing boron nitride particles having a particle diameter D50 of less than 10 µm and an average aspect ratio of 5 or less (Claim 1).

In addition, JP6231031B discloses a thermally conductive particle composition including boron nitride coarse powders having an average particle diameter of 20 to 150 µm and scaly boron nitride fine powders having an average particle diameter of 1 to 10 µm and an average thickness of 0.001 to 1 µm.

EP 3 103 766 A1 and JP 2016 135732 A describe agglomerated boron nitride particles, a production method for agglomerated boron nitride particles, resin composition including agglomerated boron nitride particles, moulded body, and sheet. JP 2015 006980 A describes a boron nitride aggregated particle, aggregated BN particle-containing resin composition, and heat-radiation sheet. JP 2018 021180 A describes an epoxy resin composition, heat conduction material precursor, B stage sheet, prepreg, heat conduction material, laminate, metal substrate and printed wiring board. JP 2013 082883 A describes a composition, B-stage sheet, prepreg, cured product of the composition, laminate, metal substrate, wiring board, and method of producing the composition. JP 2011 006586 A describes a thermosetting resin composition, thermal conductive resin sheet, manufacturing method thereof and power module. JP 2017 036415 A describes a heat release resin sheet and device containing heat release resin sheet.

### SUMMARY OF THE INVENTION

The present invention is as defined in the appended claims. The present inventors have studied a thermally conductive material composed of the compositions including boron nitride particles disclosed in WO2016/093248A and JP6231031B and have found that there is room for improvement in the adhesiveness (adhesive strength) with an object (adherend) to which the thermally conductive material should be applied to promote heat dissipation.

Therefore, an object of the present invention is to provide a composition for forming a thermally conductive material, from which a thermally conductive material having excellent thermally conductive properties and adhesiveness can be obtained.

In addition, another object of the present invention is to provide a thermally conductive material, a thermally conductive sheet, and a device with a thermally conductive layer.

As a result of a thorough examination conducted to achieve the objects, the present inventors have found that the objects can be achieved by the following configuration.

The invention is as defined in claims 1 to 6.

According to the present invention, it is possible to provide a composition for forming a thermally conductive material, from which a thermally conductive material having excellent thermally conductive properties and adhesiveness can be obtained.

In addition, according to the present invention, it is possible to provide a thermally conductive material, a thermally conductive sheet, and a device with a thermally conductive layer.

### DESCRIPTION OF THE PREFERRED EMBODIMENTS

Hereinafter, the composition for forming a thermally conductive material, the thermally conductive material, the thermally conductive sheet, and the device with a thermally conductive layer according to an embodiment of the present invention will be described in detail.

The following configuration elements are described based on the representative embodiments of the present invention in some cases, but the present invention is not limited to such an embodiment.

Moreover, in the present specification, the numerical range expressed using "to" means a range including the numerical values listed before and after "to" as a lower limit value and an upper limit value.

In addition, in the present specification, a substituent, which is not specified whether to be substituted or unsubstituted, may have an additional substituent (for example, a substituent group Y which will be described later), if possible, as long as the desired effect is not impaired. For example, the description of an "alkyl group" means a substituted or unsubstituted alkyl group (alkyl group that may have a substituent) as long as the desired effect is not impaired.

In addition, in the present specification, in a case where the description of "may have a substituent" appears, the kind of a substituent, the position of a substituent, and the number of substituents are not particularly limited. Examples of the number of substituents include 1 or 2 or more. Examples of the substituent include a monovalent nonmetallic atomic group excluding a hydrogen atom, and the substituent is preferably a group selected from the following substituent group Y.

In the present specification, examples of a halogen atom include a chlorine atom, a fluorine atom, a bromine atom, and an iodine atom.

Substituent group Y:
a halogen atom (-F, -Br, -Cl, -I), a hydroxyl group, an amino group, a carboxylic acid group and a conjugated base group thereof, a carboxylic acid anhydride group, a cyanate ester group, an unsaturated polymerizable group, an epoxy group, an oxetanyl group, an aziridinyl group, a thiol group, an isocyanate group, an thioisocyanate group, an aldehyde group, an alkoxy group, an aryloxy group, an alkylthio group, an arylthio group, an alkyldithio group, an aryldithio group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsufinyl group, an arylsulfinyl group, an alkylsulfonyl group, an arylsulfonyl group, a sulfo group (-SO₃H) and a conjugated base group thereof, an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, an N-acylsulfamoyl group and a conjugated base group thereof, an N-alkylsulfonylsulfamoyl group (-SO₂NHSO₂(alkyl)) and a conjugated base group thereof, an N-arylsulfonylsulfamoyl group (-SO₂NHSO₂(aryl)) and a conjugated base group thereof, an N-alkylsulfonylcarbamoyl group (-CONHSO₂(alkyl)) and a conjugated base group thereof, an N-arylsulfonylcarbamoyl group (-CONHSO₂(aryl)) and a conjugated base group thereof, an alkoxysilyl group (-Si(Oalkyl)₃), an aryloxysilyl group (-Si(Oaryl)₃), a hydroxysilyl group (-Si(OH)₃) and a conjugated base group thereof, a phosphono group (-PO₃H₂) and a conjugated base group thereof, a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and a conjugated base group thereof, a monoarylphosphono group (-PO₃H(aryl)) and a conjugated base group thereof, a phosphonooxy group (-OPO₃H₂) and a conjugated base group thereof, a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and a conjugated base group thereof, a monoarylphosphonooxy group (-OPO₃H(aryl)) and a conjugated base group thereof, a cyano group, a nitro group, an aryl group, an alkenyl group, an alkynyl group, and an alkyl group. In addition, each of the aforementioned groups may further have a substituent (for example, one or more groups of each of the aforementioned groups), if possible. For example, an aryl group that may have a substituent is also included as a group that can be selected from the substituent group Y.

In a case where the group selected from the substituent groups Y has a carbon atom, the number of carbon atoms of the group is, for example, 1 to 20.

The number of atoms other than the hydrogen atom of the group selected from the substituent groups Y is, for example, 1 to 30.

Moreover, these substituents may or may not form a ring by being bonded to each other, if possible, or by being bonded to a group substituted with the substituent. For example, the alkyl group (or an alkyl group moiety in a group including an alkyl group as a partial structure, such as an alkoxy group) may be a cyclic alkyl group (cycloalkyl group) or may be an alkyl group having one or more cyclic structures as a partial structure.

Hereinafter, the components contained in the composition for forming a thermally conductive material according to an embodiment of the present invention will be described.

### [Composition for forming thermally conductive material (composition)]

The composition for forming a thermally conductive material according to an embodiment of the present invention (hereinafter, also simply referred to as "composition") contains a thermosetting compound A, boron nitride particles B containing boron nitride and having an average particle diameter of 25.0 µm or more, and boron nitride particles C containing boron nitride and having an average particle diameter of 5.0 µm or less, in which an oxygen atom concentration on a surface of the boron nitride particles C detected by X-ray photoelectron spectroscopic analysis is 1.5 atomic% or more.

Although the mechanism by which the object of the present invention is achieved by the composition according to the embodiment of the present invention having the aforementioned structure and a thermally conductive material having excellent thermally conductive properties and adhesiveness is obtained is not always clear, the present inventors consider as follows.

In the related art, it has been known that thermally conductive properties of a thermally conductive material can be improved by improving a filling amount of the filler in the thermally conductive material by using two kinds of fillers having different particle diameters. The present inventors have studied an existing thermally conductive material containing two kinds of fillers, and found that in a case where the filler is made of boron nitride particles, there occurs a problem in adhesiveness between the resin obtained by curing the thermosetting compound and the boron nitride particles, and the effect of improving the adhesiveness with a surface modifier is not sufficient. It was considered that this is because the surface of the boron nitride particles was inert except for the particle edge.

On the other hand, in a case where the oxygen atom concentration on the surface of the boron nitride particles having a small particle diameter is high among the two kinds of boron nitride particles having different particle diameters, it is estimated that affinity between the boron nitride particles having a small particle diameter and a resin (in particular, resin obtained by curing an epoxy compound and a phenolic compound) is improved, and by the boron nitride particles having a small particle diameter filling a gap between the boron nitride particles having a large particle diameter and the resin, adhesiveness of the thermally conductive material is improved while maintaining excellent thermally conductive properties.

### Hereinafter, components contained in the composition will be described in detail.

### [Thermosetting compound A]

The composition according to the embodiment of the present invention contains a thermosetting compound A.

Examples of the thermosetting compound A include an epoxy compound, a phenolic compound, an oxetane compound, a melamine compound, and a urea compound.

The thermosetting compound A contains an epoxy compound and a phenolic compound.

### <Epoxy compound>

The epoxy compound is a compound having at least one epoxy group (oxiranyl group) in one molecule.

The epoxy group is a group formed by removing one or more hydrogen atoms (preferably one hydrogen atom) from an oxirane ring. If possible, the epoxy group may further have a substituent (a linear or branched alkyl group having 1 to 5 carbon atoms).

The number of epoxy groups contained in the epoxy compound is preferably 2 or greater, more preferably 2 to 40, even more preferably 2 to 10, and particularly preferably 2 to 6, in one molecule.

A molecular weight of the epoxy compound is preferably 150 to 10,000, and more preferably 150 to 2,000.

From a viewpoint that bond between a resin formed by curing a thermosetting compound and boron nitride particles B and C is further strengthened, and the adhesiveness of the thermally conductive material is more excellent, the epoxy equivalent of the epoxy compound is 130 or less.

The epoxy equivalent is a numerical value obtained by dividing the molecular weight of the epoxy compound by the number of epoxy groups contained in one molecule of the epoxy compound.

The epoxy compound also preferably has an aromatic ring group (more preferably an aromatic hydrocarbon ring group).

The epoxy compound may or may not exhibit liquid crystallinity.

That is, the epoxy compound may be a liquid crystal compound. In other words, the epoxy compound may be a liquid crystal compound having an epoxy group.

Examples of the epoxy compound (which may be a liquid crystalline epoxy compound) include a compound (rod-like compound) which has a rod-like structure in at least a portion thereof, and a compound (disk-like compound) which has a disk-like structure in at least a portion thereof.

Hereinafter, the rod-like compound and the disk-like compound will be described in detail.

### (Rod-like compound)

Examples of the epoxy compounds, which are rod-like compounds, include azomethine compound, azoxy compound, cyanobiphenyl compound, cyanophenyl ester compound, benzoic acid ester compound, cyclohexane carboxylic acid phenyl ester compound, cyanophenyl cyclohexane compound, cyano-substituted phenylpyrimidine compound, alkoxy-substituted phenylpyrimidine compound, phenyldioxane compound, tolane compound, and alkenylcyclohexyl benzonitrile compound. In addition to these low-molecular-weight compounds described above, high-molecular-weight compounds can also be used. The aforementioned high-molecular-weight compounds are high-molecular-weight compounds obtained by polymerizing rod-like compounds having a low-molecular-weight reactive group.

Examples of a preferred rod-like compound include a rod-like compound represented by General Formula (XXI).

General Formula (XXI): Q¹-L¹¹¹-A¹¹¹-L¹¹³-M-L¹¹⁴-A¹¹²-L¹¹²-Q²

In General Formula (XXI), Q¹ and Q² are each independently an epoxy group, and L¹¹¹, L¹¹², L¹¹³, and L¹¹⁴ each independently represent a single bond or a divalent linking group. A¹¹¹ and A¹¹² each independently represent a divalent linking group (spacer group) having 1 to 20 carbon atoms. M represents a mesogenic group.

The epoxy group of Q¹ and Q² may or may not have a substituent.

In General Formula (XXI), L¹¹¹, L¹¹², L¹¹³, and L¹¹⁴ each independently represent a single bond or a divalent linking group.

The divalent linking groups represented by L¹¹¹, L¹¹², L¹¹³, and L¹¹⁴ are preferably each independently a divalent linking group selected from the group consisting of -O-, -S-, -CO-, -NR¹¹²-, -CO-O-, -O-CO-O-, -CO-NR¹¹²-, -NR¹¹²-CO-, -O-CO-, -CH₂-O-, -O-CH₂-, -O-CO-NR¹¹²-, -NR¹¹²-CO-O-, and -NR¹¹²-CO-NR¹¹²-. R¹¹² is an alkyl group or a hydrogen atom having 1 to 7 carbon atoms.

Among them, L¹¹³ and L¹¹⁴ are each independently preferably -O-.

L¹¹¹ and L¹¹² are each independently preferably a single bond.

In General Formula (XXI), A¹¹¹ and A¹¹² each independently represent a divalent linking group having 1 to 20 carbon atoms.

The divalent linking group may contain heteroatoms such as non-adjacent oxygen atoms and sulfur atoms. Among them, an alkylene group, an alkenylene group, or an alkynylene group, having 1 to 12 carbon atoms, are preferable. The alkylene group, alkenylene group, or alkynylene group may or may not have an ester bond (-CO-O-).

The divalent linking group is preferably linear. In addition, the divalent linking group may or may not have a substituent. Examples of the substituent include a halogen atom (fluorine atom, chlorine atom, and bromine atom), a cyano group, a methyl group, and an ethyl group.

Among them, A¹¹¹ and A¹¹² are each independently preferably an alkylene group having 1 to 12 carbon atoms, and more preferably a methylene group.

In General Formula (XXI), M represents a mesogenic group. Examples of the mesogenic group include a known mesogenic group. Among them, a group represented by General Formula (XXII) is preferable.

General Formula (XXII): -(W¹-L¹¹⁵ )ₙ-W²-

In General Formula (XXII), W¹ and W² each independently represent a divalent cyclic alkylene group, a divalent cyclic alkenylene group, an arylene group, or a divalent heterocyclic group. L¹¹⁵ represents a single bond or a divalent linking group. n represents an integer of 1 to 4.

Examples of W¹ and W² include 1,4-cyclohexanediyl, 1,4-cyclohexenediyl, 1,4-phenylene, pyrimidine-2,5-diyl, pyridine-2,5-diyl, 1,3,4-thiadiazole-2,5-diyl, 1,3,4-oxadiazole-2,5-diyl, naphthalene-2,6-diyl, naphthalene-1,5-diyl, thiophene-2,5-diyl, and pyridazine-3,6-diyl. In a case of 1,4-cyclohexanediyl, 1,4-cyclohexanediyl may be any one isomer of structural isomers of a trans-isomer and a cis-isomer, or a mixture in which the isomers are mixed at any ratio. Among them, the trans-isomer is preferable.

W¹ and W² may each have a substituent. Examples of the substituent include groups exemplified in the aforementioned substituent group Y, and more specific examples thereof include a halogen atom (fluorine atom, chlorine atom, bromine atom, and iodine atom), a cyano group, an alkyl group having 1 to 10 carbon atoms (for example, methyl group, ethyl group, propyl group), an alkoxy group having 1 to 10 carbon atoms (for example, methoxy group, ethoxy group), an acyl group having 1 to 10 carbon atoms (for example, formyl group, acetyl group), an alkoxycarbonyl group having 1 to 10 carbon atoms (for example, methoxycarbonyl group, ethoxycarbonyl group), an acyloxy group having 1 to 10 carbon atoms (for example, acetyloxy group, propionyloxy group), a nitro group, a trifluoromethyl group, and a difluoromethyl group.

In a case where there are a plurality of W¹'s, the plurality of W¹'s may be the same as or different from each other.

In General Formula (XXII), L¹¹⁵ represents a single bond or a divalent linking group. As the divalent linking group represented by L¹¹⁵, a specific example of the aforementioned divalent linking group represented by L¹¹¹ to L¹¹⁴ is exemplified, and examples thereof include -CO-O-, -O-CO-, -CH₂-O-, and -O-CH₂-.

In a case where there are a plurality of L¹¹⁵'s, the plurality of L¹¹⁵'s may be the same as or different from each other.

The preferred skeleton of the basic skeleton of the mesogenic group represented by General Formula (XXII) is illustrated below. The mesogenic groups may be substituted with substituents on these skeletons.

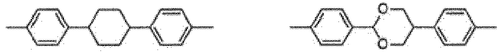

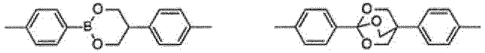

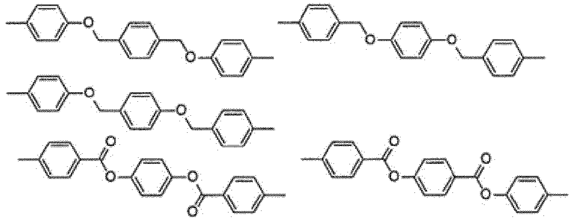

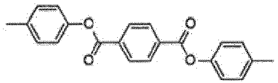

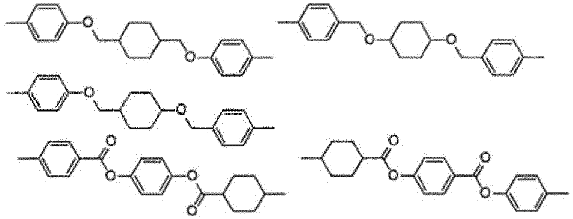

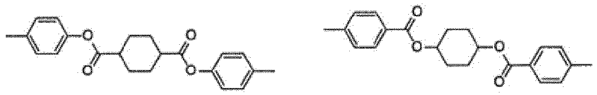

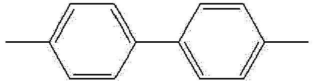

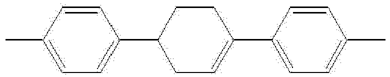

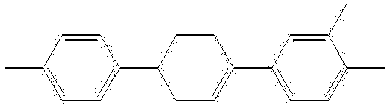

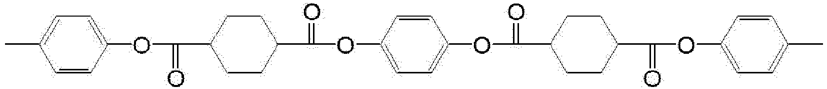

Among the skeletons, a biphenyl skeleton is preferable in that the obtained thermally conductive material has more excellent thermally conductive properties.

The compound represented by General Formula (XXI) can be synthesized by referring to the method described in JP1999-513019A (JP-H11-513019A) (WO97/00600).

The rod-like compound may be a monomer having a mesogenic group described in JP1999-323162A (JP-H11-323162A) and JP4118691B.

Among them, the rod-like compound is preferably a compound represented by General Formula (E1).

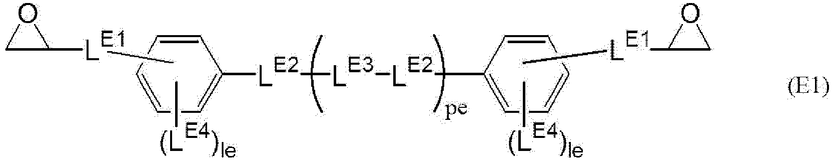

In General Formula (E1), L^{E1}'s each independently represent a single bond or a divalent linking group.

Among them, L^{E1} is preferably a divalent linking group.

The divalent linking group is preferably -O-, -S-, -CO-, -NH-, -CH=CH-, -C≡C-, -CH=N-, -N=CH-, -N=N-, an alkylene group which may have a substituent, or a group obtained by combining two or more thereof, and more preferably -O-alkylene group- or -alkylene group-O-.

Moreover, the alkylene group may be any of linear, branched, or cyclic, but is preferably a linear alkylene group having 1 or 2 carbon atoms.

The plurality of L^{E1}'s may be the same as or different from each other.

In General Formula (E1), L^{E2}'s each independently represent a single bond, -CH=CH-, -CO-O-, -O-CO-, -C(-CH₃)=CH-, -CH=C(-CH₃)-, -CH=N-, -N=CH-, -N=N-, -C≡C-, -N=N⁺(-O⁻)-, -N⁺(-O⁻)=N-, -CH=N⁺(-O⁻)-, -N⁺(-O⁻)=CH-, -CH=CH-CO-, -CO-CH=CH-, -CH=C(-CN)-, or -C(-CN)=CH-.

Among them, L^{E2}'s are each independently preferably a single bond, -CO-O-, or -O-CO-.

In a case where there are a plurality of L^{E2}'s, the plurality of L^{E2}'s may be the same as or different from each other.

In General Formula (E1), L^{E3} 's each independently may have a single bond or a substituent, and represent a 5-membered or 6-membered aromatic ring group or a 5-membered or 6-membered non-aromatic ring group, or a polycyclic group consisting of these rings.

Examples of the aromatic ring group and non-aromatic ring group represented by L^{E3} include a 1,4-cyclohexanediyl group, a 1,4-cyclohexenediyl group, a 1,4-phenylene group, a pyrimidine-2,5-diyl group, a pyridine-2,5-diyl group, a 1,3,4-thiadiazole-2,5-diyl group, a 1,3,4-oxadiazole-2,5-diyl group, a naphthalene-2,6-diyl group, a naphthalene-1,5-diyl group, a thiophene-2,5-diyl group, and a pyridazine-3,6-diyl group, each of which may have a substituent. In a case of the 1,4-cyclohexanediyl group, the group may be any one isomer of structural isomers of a trans-isomer and a cis-isomer, or a mixture in which the isomers are mixed at any ratio. Among them, a trans-isomer is preferable.

Among them, L^{E3} is preferably a single bond, a 1,4-phenylene group, or a 1,4-cyclohexenediyl group.

The substituents contained in the groups represented by L^{E3} are each independently preferably an alkyl group, an alkoxy group, a halogen atom, a cyano group, a nitro group, or an acetyl group, and more preferably an alkyl group (preferably having one carbon atom).

In a case where there are a plurality of substituents, these substituents may be the same as or different from each other.

In a case where there are a plurality of L^{E3}'s, the plurality of L^{E3}'s may be the same as or different from each other.

In General Formula (E1), pe represents an integer of 0 or greater.

In a case where pe is an integer of 2 or greater, a plurality of (-L^{E3}-L^{E2}-)'s may be the same as or different from each other.

Among them, pe is preferably 0 to 2, more preferably 0 or 1, and even more preferably 0.

In General Formula (E1), L^{E4}'s each independently represent a substituent.

The substituents are each independently preferably an alkyl group, an alkoxy group, a halogen atom, a cyano group, a nitro group, or an acetyl group, and more preferably an alkyl group (preferably having one carbon atom).

A plurality of L^{E4}'s may be the same as or different from each other. In addition, in a case where le described below is an integer of 2 or greater, the plurality of L^{E4}'s present in the same (L^{E4})ₗₑ may also be the same as or different from each other.

In General Formula (E1), le's each independently represent an integer of 0 to 4. Among them, le's are each independently preferably 0 to 2.

A plurality of le's may be the same as or different from each other.

The rod-like compound preferably has a biphenyl skeleton in that the obtained thermally conductive material has more excellent thermally conductive properties.

In other words, the epoxy compound preferably has a biphenyl skeleton, and the epoxy compound in this case is more preferably a rod-like compound.

### (Disk-like compound)

The epoxy compound, which is a disk-like compound, has a disk-like structure in at least a portion thereof.

The disk-like structure has at least an alicyclic ring or an aromatic ring. In particular, in a case where the disk-like structure has an aromatic ring, the disk-like compound can form a columnar structure by forming a stacking structure based on the intermolecular π-π interaction.

Examples of the disk-like structure include the triphenylene structure described in Angew. Chem. Int. Ed. 2012, 51, 7990 to 7993, or JP1995-306317A (JP-H07-306317A), and the trisubstituted benzene structures described in JP2007-002220A and JP2010-244038A.

In a case where a disk-like compound is used as the epoxy compound, a thermally conductive material exhibiting high thermally conductive properties can be obtained. The reason is that since the rod-like compound can conduct heat only linearly (one-dimensionally), whereas the disk-like compound can conduct heat planarly (two-dimensionally) in a normal direction, it is considered that the thermal conduction path increases and the thermal conductivity improves.

The disk-like compound preferably has three or more epoxy groups. The cured substance of the composition including the disk-like compound having three or more epoxy groups tends to have a high glass transition temperature and high heat resistance.

The number of epoxy groups contained in the disk-like compound is preferably 8 or less and more preferably 6 or less.

Specific examples of the disk-like compound include compounds which have at least one (preferably, three or more) of terminals as an epoxy group in the compounds described in C. Destrade et al., Mol. Crysr. Liq. Cryst., vol. 71, page 111 (1981); edited by The Chemical Society of Japan, Quarterly Review of Chemistry, No. 22, Chemistry of liquid crystal, Chapter 5, Chapter 10, Section 2 (1994); B. Kohne et al., Angew. Chem. Soc. Chem. Comm., page 1794 (1985); J. Zhang et al., J. Am. Chem. Soc., vol. 116, page 2655 (1994); and JP4592225B.

In addition, examples of the disk-like compound include compounds which have at least one (preferably, three or more) of terminals as an epoxy group in the triphenylene structures described in Angew. Chem. Int. Ed. 2012, 51, 7990 to 7993 and JP1995-306317A (JP-H07-306317A) and the trisubstituted benzene structures described in JP2007-002220A and JP2010-244038A.

As the disk-like compound, a compound represented by any of Formulae (D1) to (D16) is preferable from the viewpoint of more excellent thermally conductive properties of the thermally conductive material.

First, Formulae (D1) to (D15) will be described, and then Formula (D16) will be described.

In the following formulae, "-LQ" represents "-L-Q", and "QL-" represents "Q-L-".

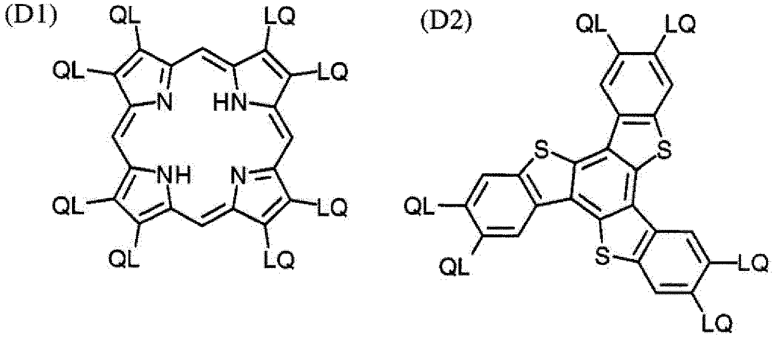

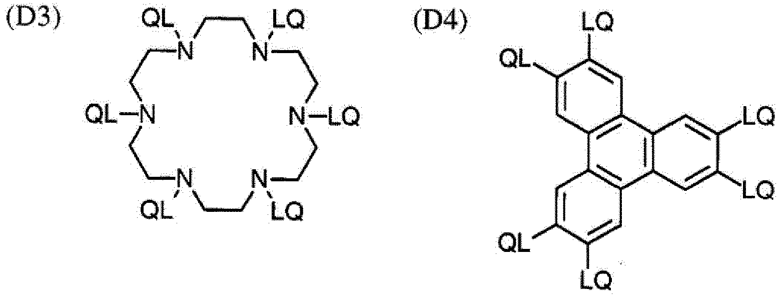

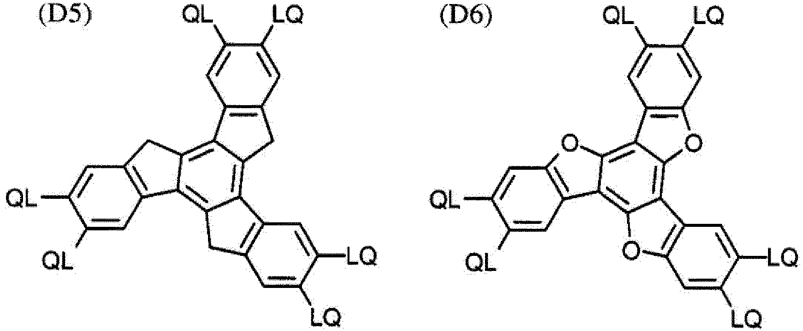

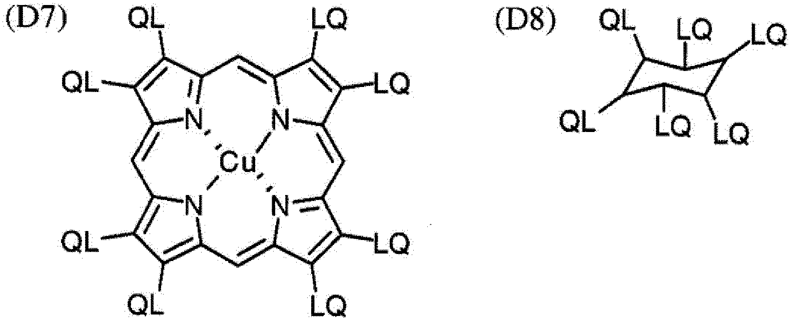

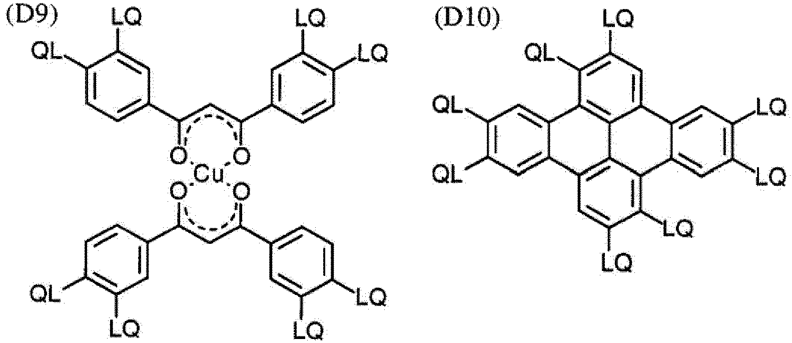

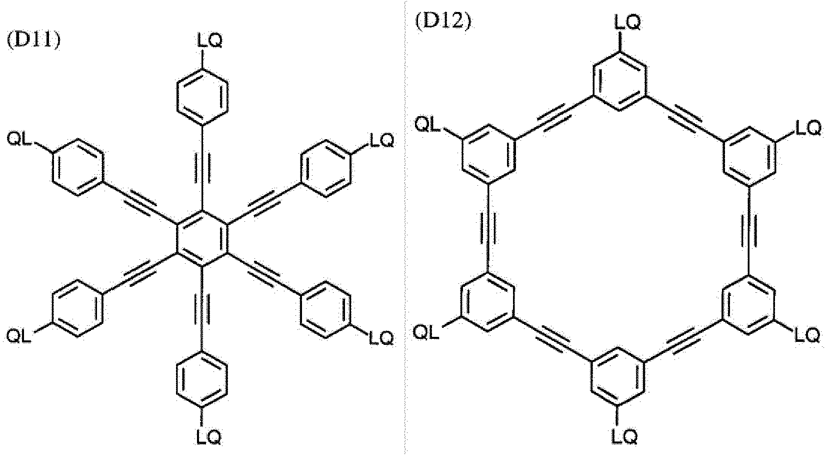

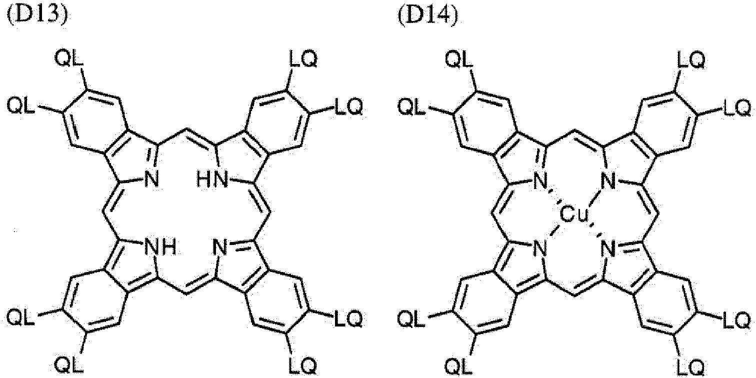

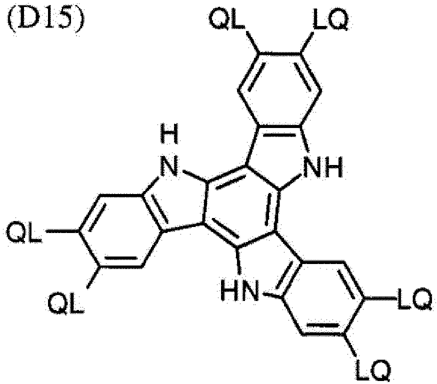

In Formulae (D1) to (D15), L represents a divalent linking group.

From the viewpoint of more excellent thermally conductive properties of the thermally conductive material, L is each independently preferably an alkylene group, an alkenylene group, an arylene group, and a group selected from the group consisting of -CO-, -NH-, -O-, -S-, and a combination thereof, and more preferably an alkylene group, an alkenylene group, an arylene group, and a group obtained by combining two or more groups selected from the group consisting of -CO-, -NH-, -O-, and -S-.

The number of carbon atoms in the alkylene group is preferably 1 to 12. The number of carbon atoms in the alkenylene group is preferably 2 to 12. The number of carbon atoms in the arylene group is preferably 10 or less.

The alkylene group, the alkenylene group, and the arylene group may have a substituent (preferably, an alkyl group, a halogen atom, a cyano group, an alkoxy group, an acyloxy group).

An example of L is shown below. In the following example, a bonding site on the left side is bonded to a central structure of the compound represented by any of Formulae (D1) to (D15) (hereinafter, also simply referred to as "central ring"), and a bonding site on the right side is bonded to Q.

AL means an alkylene group or an alkenylene group, and AR means an arylene group.
L101: -AL-CO-O-AL-
L102: -AL-CO-O-AL-O-
L103: -AL-CO-O-AL-O-AL-
L104: -AL-CO-O-AL-O-CO-
L105: -CO-AR-O-AL-
L106: -CO-AR-O-AL-O-
L107: -CO-AR-O-AL-O-CO-
L108: -CO-NH-AL-
L109: -NH-AL-O-
L110: -NH-AL-O-CO-
L111: -O-AL-
L112: -O-AL-O-
L113: -O-AL-O-CO-
L114: -O-AL-O-CO-NH-AL-
L115: -O-AL-S-AL-
L116: -O-CO-AL-AR-O-AL-O-CO-
L117: -O-CO-AR-O-AL-CO-
L118: -O-CO-AR-O-AL-O-CO-
L119: -O-CO-AR-O-AL-O-AL-O-CO-
L120: -O-CO-AR-O-AL-O-AL-O-AL-O-CO-
L121: -S-AL-
L122: -S-AL-O-
L123: -S-AL-O-CO-
L124: -S-AL-S-AL-
L125: -S-AR-AL-
L126: -O-CO-AL-
L127: -O-CO-AL-O-
L128: -O-CO-AR-O-AL-
L129: -O-CO-
L130: -O-CO-AR-O-AL-O-CO-AL-S-AR-
L131: -O-CO-AL-S-AR-
L132: -O-CO-AR-O-AL-O-CO-AL-S-AL-
L133: -O-CO-AL-S-AR-
L134: -O-AL-S-AR-
L135: -AL-CO-O-AL-O-CO-AL-S-AR-
L136: -AL-CO-O-AL-O-CO-AL-S-AL-
L137: -O-AL-O-AR-
L138: -O-AL-O-CO-AR-
L139: -O-AL-NH-AR-
L140: -O-CO-AL-O-AR-
L141: -O-CO-AR-O-AL-O-AR-
L142: -AL-CO-O-AR-
L143: -AL-CO-O-AL-O-AR-

In Formulae (D1) to (D15), Q each independently represents a hydrogen atom or a substituent.

Examples of the substituent include groups exemplified in the aforementioned substituent group Y. More specifically, examples of the substituent include the aforementioned reactive functional group, a halogen atom, an isocyanate group, a cyano group, an unsaturated polymerizable group, an epoxy group, an oxetanyl group, an aziridinyl group, a thioisocyanate group, an aldehyde group, and a sulfo group.

However, in a case where Q is a group other than the epoxy group, Q is preferably stable with respect to the epoxy group.

In Formulae (D1) to (D15), one or more (preferably two or more) Qs represent an epoxy group. Among them, it is preferable that all Qs represent epoxy groups from the viewpoint of more excellent thermally conductive properties of the thermally conductive material.

The compounds represented by Formulae (D1) to (D15) preferably do not have -NH- from the viewpoint of the stability of the epoxy group.

Among the compounds represented by Formulae (D1) to (D15), the compound represented by Formula (D4) is preferable from the viewpoint of more excellent thermally conductive properties of the thermally conductive material. In other words, the central ring of the disk-like compound is preferably a triphenylene ring.

As the compound represented by Formula (D4), the compound represented by Formula (XI) is preferable from the viewpoint of more excellent thermally conductive properties of the thermally conductive material.

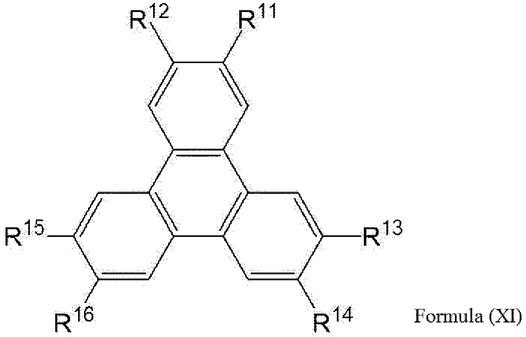

In Formula (XI), R¹¹, R¹², R¹³, R¹⁴, R¹⁵, and R¹⁶ each independently represent *-X¹¹-L¹¹-P¹¹ or *-X¹²-L¹²-Y¹².
* represents the bonding position with a triphenylene ring.

Among R¹¹, R¹², R¹³, R¹⁴, R¹⁵, and R¹⁶, two or more are *-X¹¹-L¹¹-P¹¹, and three or more are preferably *-X¹¹-L¹¹-P¹¹.

Among them, from the viewpoint of more excellent thermally conductive properties of the thermally conductive material, one or more of R¹¹ or R¹², one or more of R¹³ or R¹⁴, and one or more of R¹⁵ or R¹⁶ are preferably *-X¹¹-L¹¹-P¹¹.

It is more preferable that R¹¹, R¹², R¹³, R¹⁴, R¹⁵, and R¹⁶ are all *-X¹¹-L¹¹-P¹¹. In addition, it is even more preferable that R¹¹, R¹², R¹³, R¹⁴, R¹⁵, and R¹⁶ are all the same.

X¹¹ each independently represents a single bond, -O-, -CO-, -NH-, -O-CO-, -O-CO-O-, -O-CO-NH-, -O-CO-S-, -CO-O-, -CO-NH-, -CO-S-, -NH-CO-, -NH-CO-O-, -NH-CO-NH-, -NH-CO-S-, -S-, -S-CO-, -S-CO-O-, -S-CO-NH-, or -S-CO-S-.

Among them, X¹¹ is each independently preferably -O-, -O-CO-, -O-CO-O-, -O-CO-NH-, -CO-O-, -CO-NH-, -NH-CO-, or -NH-CO-O-, and more preferably -O-, -O-CO-, -CO-O-, -O-CO-NH-, or -CO-NH-, and even more preferably -O-CO- or -CO-O-.

L¹¹ each independently represents a single bond or a divalent linking group.

Examples of the divalent linking group, include -O-, -O-CO-, -CO-O-, -S-, -NH-, an alkylene group (the number of carbon atoms is preferably 1 to 10, more preferably 1 to 8, and even more preferably 1 to 7), an arylene group (the number of carbon atoms is preferably 6 to 20, more preferably 6 to 14, and even more preferably 6 to 10), or a group obtained by combining these groups.

Examples of the alkylene group include a methylene group, an ethylene group, a propylene group, a butylene group, a pentylene group, a hexylene group, and a heptylene group.

Examples of the arylene group include a 1,4-phenylene group, a 1,3-phenylene group, a 1,4-naphthylene group, a 1,5-naphthylene group, and an anthracenylene group, and a 1,4-phenylene group is preferable.

The alkylene group and the arylene group may each have a substituent. The number of substituents is preferably 1 to 3, and more preferably 1. The substitution position of the substituent is not particularly limited. As the substituent, a halogen atom or an alkyl group having 1 to 3 carbon atoms is preferable, and a methyl group is more preferable.

It is also preferable that the alkylene group and the arylene group are unsubstituted. Among them, the alkylene group is preferably unsubstituted.

Examples of -X¹¹-L¹¹- include L101 to L143, which are examples of the aforementioned L.

P¹¹ represents an epoxy group. The epoxy group may or may not have a substituent.

X¹² is the same as X¹¹, and the preferred conditions are also the same.

L¹² is the same as L¹¹, and the preferred conditions are also the same.

Examples of -X¹²-L¹²- include L101 to L143, which are examples of the aforementioned L.

Y¹² represents a group in which one or two or more methylene groups in a hydrogen atom, a linear, branched, or cyclic alkyl group having 1 to 20 carbon atoms, or a linear, branched, or cyclic alkyl group having 1 to 20 carbon atoms are substituted with -O-, -S-, -NH-, -N (CH₃)-, -CO-, -O-CO-, or -CO-O-.

In a case where in Y¹², one or two or more methylene groups in a linear, branched, or cyclic alkyl group having 1 to 20 carbon atoms, or a linear, branched, or cyclic alkyl group having 1 to 20 carbon atoms are groups substituted with -O-, -S-, -NH-, -N(CH₃)-, -CO-, -O-CO-, or -CO-O-, one or more of the hydrogen atoms contained in Y¹² may be substituted with halogen atoms.

Specific examples of the compound represented by Formula (XI) include a compound in which at least one (preferably three or more) of terminals is an epoxy group in the compound described in paragraphs 0028 to 0036 of JP1995-281028A (JP-H07-281028A), JP1995-306317A (JP-H07-306317A), paragraphs 0016 to 0018 of JP2005-156822A, paragraphs 0067 to 0072 of JP2006-301614A, and pages 330 to 333 of Handbook of Liquid Crystals (published by Maruzen Co., Ltd., 2000).

The compound represented by Formula (XI) can be synthesized in accordance with the methods described in JP1995-306317A (JP-H07-306317A), JP1995-281028A (JP-H07-281028A), JP2005-156822A, and JP2006-301614A.

In addition, from the viewpoint of more excellent thermally conductive properties of the thermally conductive material, the compound represented by Formula (D16) is also preferable as the disk-like compound.

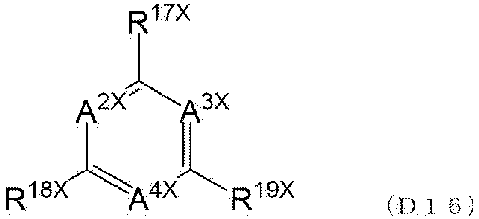

In Formula (D16), A^{2X}, A^{3X}, and A^{4X} each independently represent -CH= or -N=. Among them, A^{2X}, A^{3X}, and A^{4X} each independently preferably represent -CH=.

R^{17X}, R^{18X}, and R^{19X} each independently represent *-X^{211X}-(Z^{21X}-X^{212X})_{n21X}-L^{21X}-Q. * represents a bonding position with a central ring.

X^{211X} and X^{212X} each independently represent a single bond, -O-, -CO-, -NH-, -O-CO-, -O-CO-O-, -O-CO-NH-, -O-CO-S-, -CO-O-, -CO-NH-, -CO-S-, -NH-CO-, -NH-CO-O-, -NH-CO-NH-, -NH-CO-S -, -S-, -S-CO-, -S-CO-O-, -S-CO-NH-, or -S-CO-S-.

Z^{21X} each independently represents a 5-membered or 6-membered aromatic ring group or a 5-membered or 6-membered non-aromatic ring group.

L^{21X} represents a single bond or a divalent linking group.

Q is synonymous with Q in Formulae (D1) to (D15), and the preferable conditions are also the same. In Formula (D16), at least one (preferably all) Q among the plurality of Qs represents an epoxy group.

n21X represents an integer of 0 to 3. In a case where n21X is 2 or greater, a plurality of (Z^{21X}-X^{212X}) may be the same or different.

However, the compound represented by Formula (D16) preferably does not have -NH- from the viewpoint of the stability of the epoxy group.

As the compound represented by Formula (D16), the compound represented by Formula (XII) is preferable.

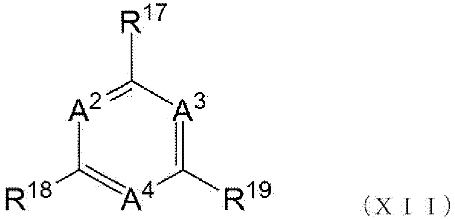

In Formula (XII), A², A³, and A⁴ each independently represent -CH= or -N=. Among them, A², A³, and A⁴ preferably represent -CH=. In other words, it is also preferable that the central ring of the disk-like compound is a benzene ring.

R¹⁷, R¹⁸, and R¹⁹ each independently represent *-X²¹¹-(Z²¹-X²¹²)ₙ₂₁-L²¹-P²¹ or *-X²²¹-(Z²²-X²²²)ₙ₂₂-Y²². * represents a bonding position with a central ring.

Two or more of R¹⁷, R¹⁸, and R¹⁹ are *-X²¹¹-(Z²¹-X²¹²)ₙ₂₁-L²¹-P²¹. From the viewpoint of more excellent thermally conductive properties of the thermally conductive material, it is preferable that all of R¹⁷, R¹⁸, and R¹⁹ are *-X²¹¹-(Z²¹-X²¹²)ₙ₂₁-L²¹-P²¹.

In addition, it is preferable that R¹⁷, R¹⁸, and R¹⁹ are all the same.

X²¹¹, X²¹², X²²¹, and X²²² each independently represent a single bond, -O-, -CO-, -NH-, -O-CO-, -O-CO-O-, -O-CO-NH-, -O-CO-S-, -CO-O-, -CO-NH-, -CO-S-, -NH-CO-, -NH-CO-O-, -NH-CO-NH-, -NH-CO-S-, -S-, -S-CO-, -S-CO-O-, -S-CO-NH-, or -S-CO-S-.

Among them, X²¹¹, X²¹², X²²¹, and X²²² are each independently preferably a single bond, -O-, -CO-O-, or -O-CO-.

Z²¹ and Z²² each independently represent a 5-membered or 6-membered aromatic ring group, or a 5-membered or 6-membered non-aromatic ring group, and examples thereof include a 1,4-phenylene group, a 1,3-phenylene group, and an aromatic heterocyclic group.

The aromatic ring group and the non-aromatic ring group may have a substituent. The number of substituents is preferably 1 or 2, and more preferably 1. The substitution position of the substituent is not particularly limited. As the substituent, a halogen atom or a methyl group is preferable. It is also preferable that the aromatic ring group and the non-aromatic ring group are unsubstituted.

Examples of the aromatic heterocyclic group include the following aromatic heterocyclic groups.

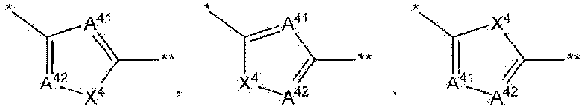

In the formula, * represents a site that is bonded to X²¹¹ or X²²¹. ** represents a site that is bonded to X²¹² or X²²². A⁴¹ and A⁴² each independently represent a methine group or a nitrogen atom. X⁴ represents an oxygen atom, a sulfur atom, or an imino group.

Preferably at least one of A⁴¹ or A⁴² is a nitrogen atom, and more preferably both of A⁴¹ and A⁴² are nitrogen atoms. In addition, X⁴ is preferably an oxygen atom.

In a case where n21 and n22 to be described later are two or greater, a plurality of (Z²¹-X²¹²) and (Z²²-X²²²) may be the same or different, respectively.

L²¹ each independently represents a single bond or a divalent linking group, and is synonymous with L¹¹ in the aforementioned Formula (XI). L²¹ is preferably -O-, -O-CO-, -CO-O-, -S-, -NH-, and an alkylene group (the number of carbon atoms is preferably 1 to 10, more preferably 1 to 8, and even more preferably 1 to 7), an arylene group (the number of carbon atoms is preferably 6 to 20, more preferably 6 to 14, and even more preferably 6 to 10), or a group obtained by combining these.

In a case where n22 to be described later is 1 or greater, examples of -X²¹²-L²¹- similarly include L101 to L143, which are examples of L in the aforementioned Formulae (D1) to (D15).

P²¹ represents an epoxy group. The epoxy group may or may not have a substituent.

Y²² each independently represents a group in which one or two or more methylene groups in a hydrogen atom, a linear, branched, or cyclic alkyl group having 1 to 20 carbon atoms, or a linear, branched, or cyclic alkyl group having 1 to 20 carbon atoms are substituted with -O-, -S-, -NH-, -N(CH₃)-, -CO-, -O-CO-, or -CO-O-, and is synonymous with Y¹² in General Formula (XI), and the preferred range is also the same.

n21 and n22 each independently represent an integer of 0 to 3, and from the viewpoint of more excellent thermally conductive properties, preferably an integer of 1 to 3, and more preferably an integer of 2 or 3.

Preferred examples of the disk-like compound include the following compounds.

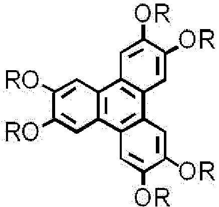

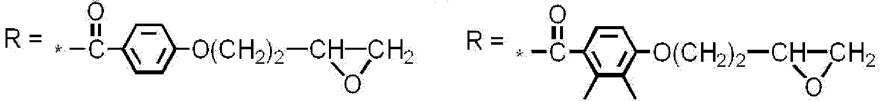

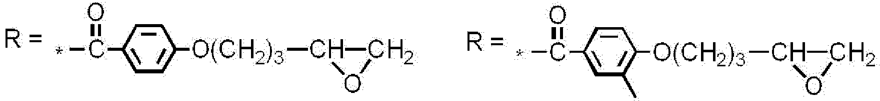

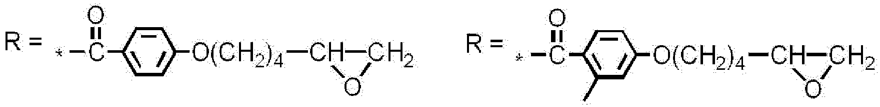

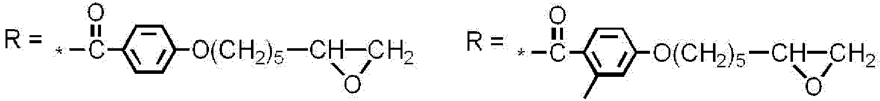

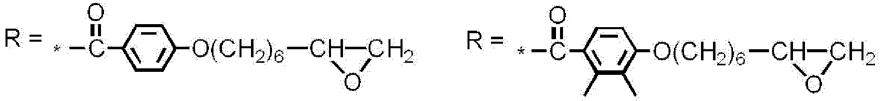

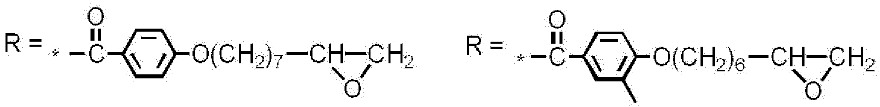

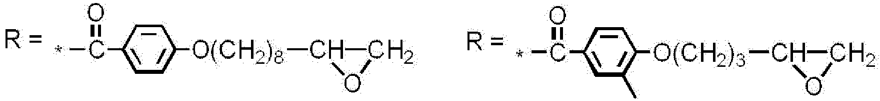

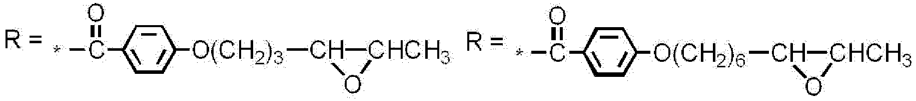

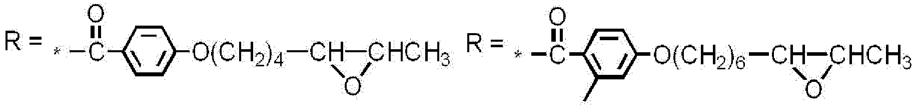

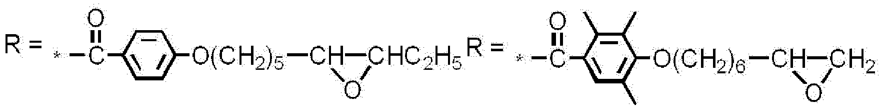

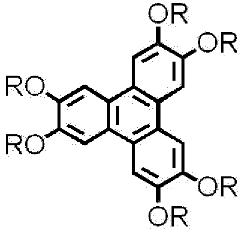

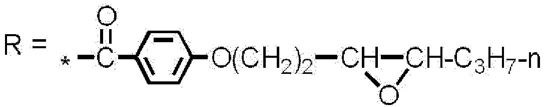

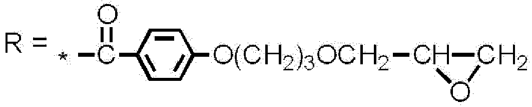

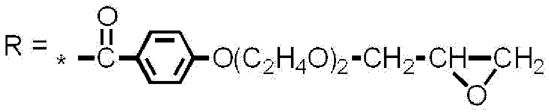

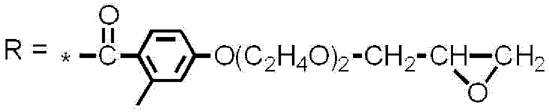

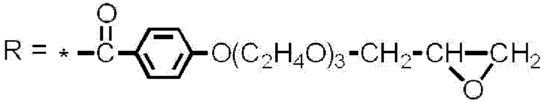

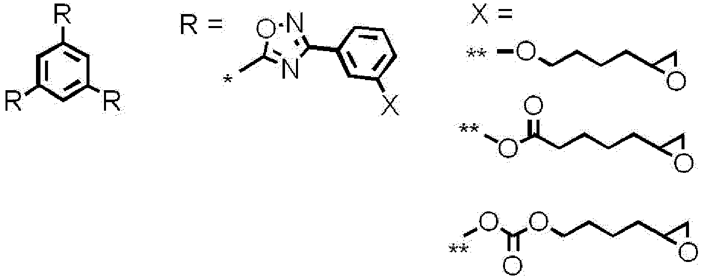

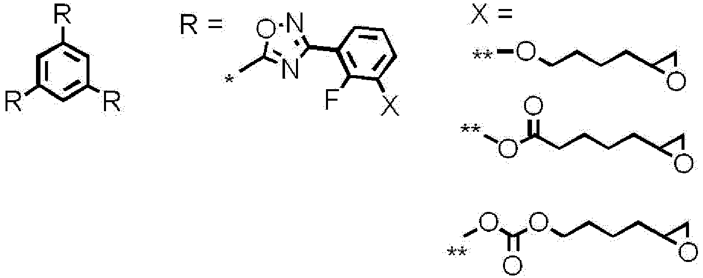

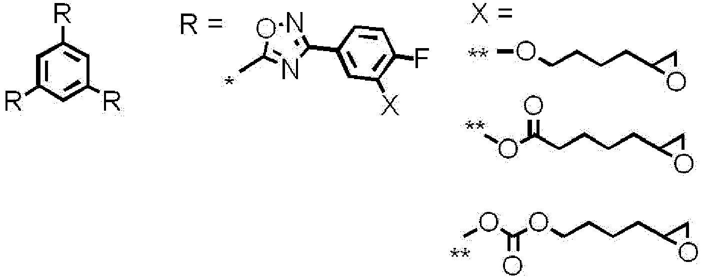

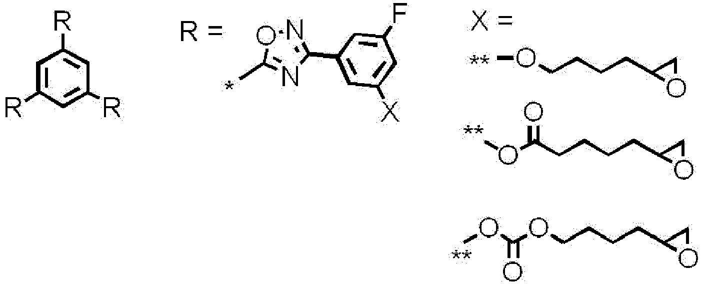

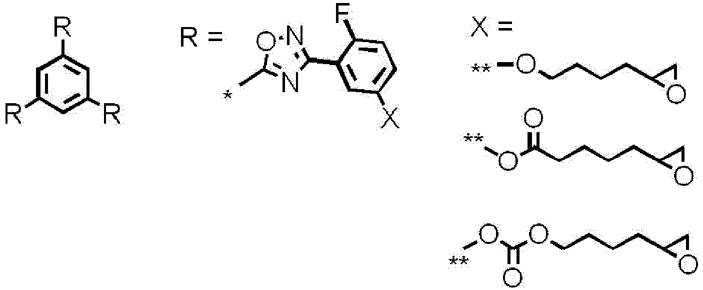

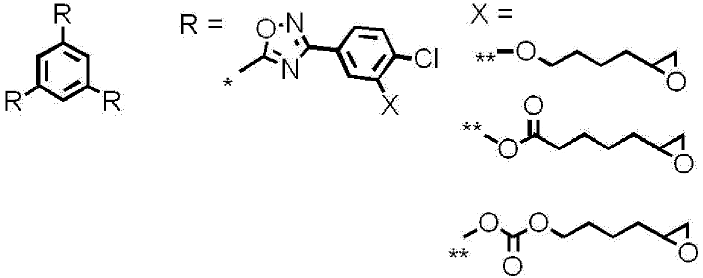

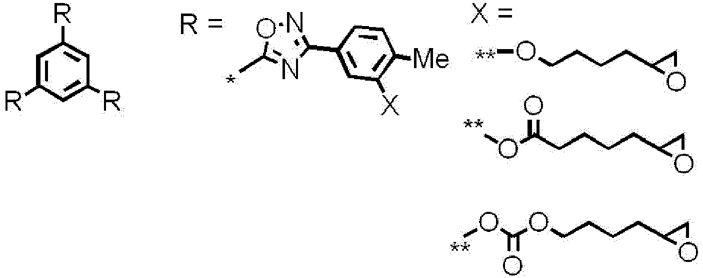

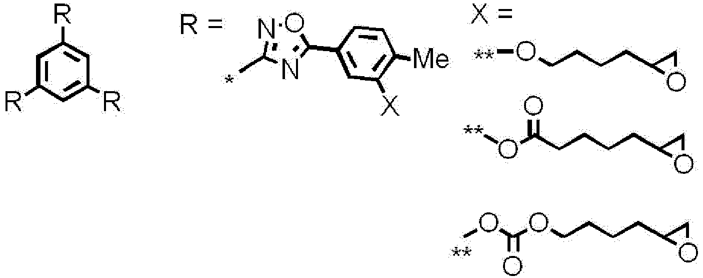

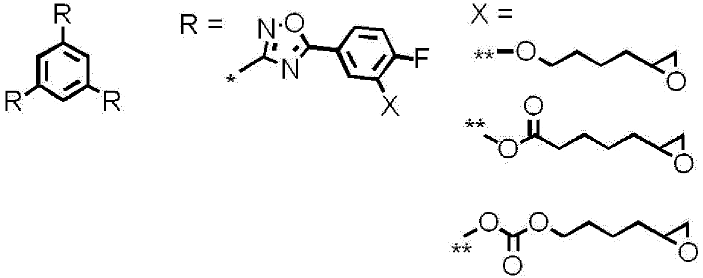

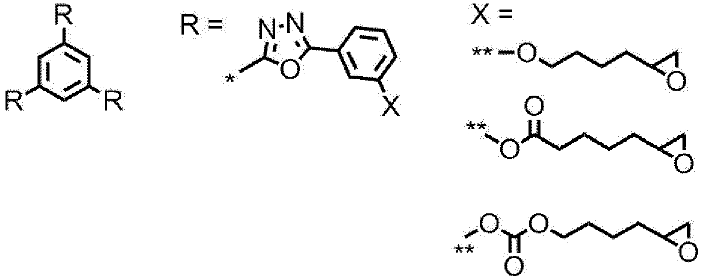

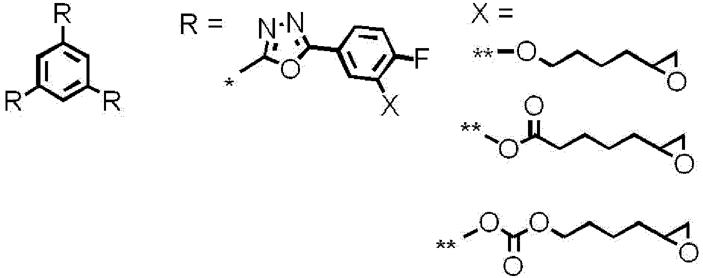

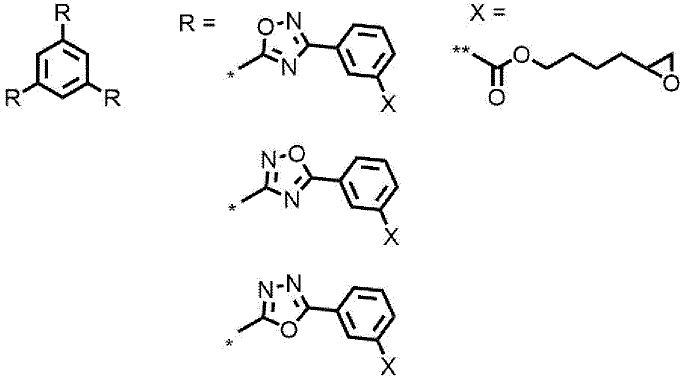

In the following structural formula, R represents -X²¹²-L²¹-P²¹.

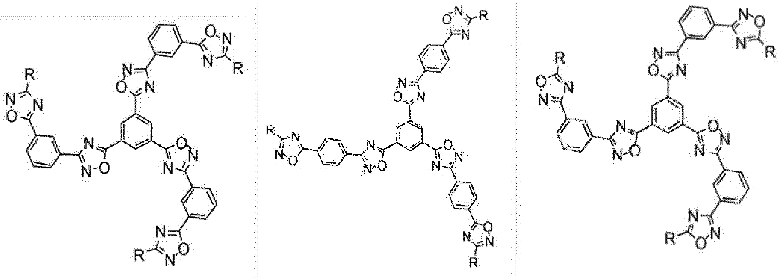

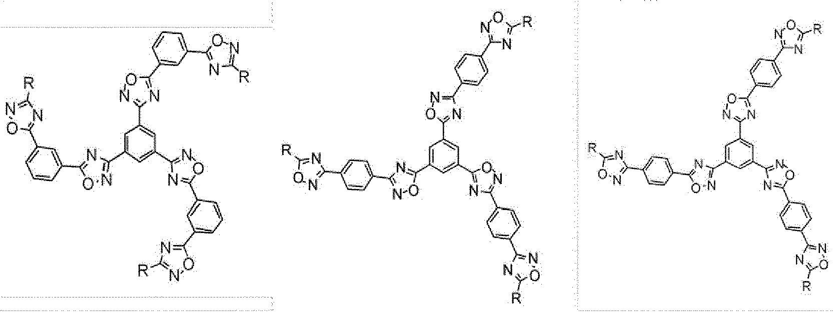

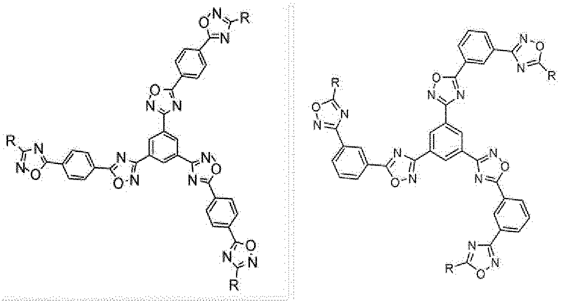

For details and specific examples of the compound represented by Formula (XII), a compound in which at least one (preferably three or more) of terminals in the compounds described in paragraphs 0013 to 0077 of JP2010-244038A is an epoxy group can be referred to.

The compound represented by Formula (XII) can be synthesized in accordance with the methods described in JP2010-244038A, JP2006-076992A, and JP2007-002220A.

The disk-like compound is preferably a compound having a hydrogen-bonding functional group from the viewpoint of reducing the electron density, strengthening the stacking, and facilitating the formation of a columnar aggregate. Examples of the hydrogen-bonding functional group include -O-CO-NH-, -CO-NH-, -NH-CO-, -NH-CO-O-, -NH-CO-NH-, -NH-CO-S-, and -S-CO-NH-.

### (Other epoxy compounds)

Examples of epoxy compounds other than the aforementioned epoxy compound include an epoxy compound represented by General Formula (DN).

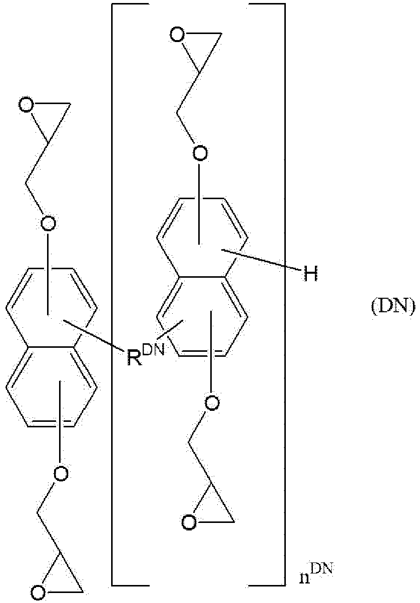

In General Formula (DN), n^{DN} represents an integer of 0 or greater, preferably 0 to 5, and more preferably 1.

R^{DN} represents a single bond or a divalent linking group. The divalent linking group is preferably -O-, -O-CO-, -CO-O-, -S-, an alkylene group (the number of carbon atoms is preferably 1 to 10), an arylene group (the number of carbon atoms is preferably 6 to 20), or a group obtained by combining these groups, more preferably an alkylene group, and even more preferably a methylene group.

Examples of other epoxy compounds include compounds in which the epoxy group is fused. Examples of such a compound include 3,4: 8,9-diepoxybicyclo [4.3.0] nonane.

Examples of the other epoxy compounds include, in addition to the aforementioned epoxy compounds, a bisphenol A-type epoxy compound, a bisphenol F-type epoxy compound, a bisphenol S-type epoxy compound, and a bisphenol AD-type epoxy compound, which are glycidyl ethers of bisphenol A, F, S, and AD; a hydrogenated bisphenol A-type epoxy compound and a hydrogenated bisphenol AD-type epoxy compound; a phenol novolac-type glycidyl ether (phenol novolac-type epoxy compound), a cresol novolac-type glycidyl ether (cresol novolac-type epoxy compound), and a bisphenol A novolac-type glycidyl ether; a dicyclopentadiene-type glycidyl ether (dicyclopentadiene-type epoxy compound); a dihydroxypentadiene-type glycidyl ether (dihydroxypentadiene-type epoxy compound); a polyhydroxybenzene-type glycidyl ether (polyhydroxybenzene-type epoxy compound); a benzene polycarboxylic acid-type glycidyl ester (benzene polycarboxylic acid-type epoxy compound); and a trisphenol methane-type epoxy compound.

One kind of the epoxy compounds may be used singly, or two or more kinds thereof may be used.

In a case where the composition contains the epoxy compound, the content of the epoxy compound is preferably 1.0% to 25.0% by mass, more preferably 3.0% to 20.0% by mass, and even more preferably 5.0% to 20.0% by mass, with respect to the total solid content of the composition.

In addition, the "total solid content" of the composition is intended to mean a component forming a thermally conductive material, and does not contain a solvent. Here, the component for forming a thermally conductive material may be a component of which chemical structure changes by reacting (polymerizing) at a time of forming the thermally conductive material. In addition, in a case where the component is a component for forming a thermally conductive material, even if properties thereof is liquid, the component is regarded as a solid content.

### <Phenolic compound>

The phenolic compound is a compound having one or more (preferably two or more, and more preferably three or more) phenolic hydroxyl groups.

As the phenolic compound, a compound represented by General Formula (P1) is preferable.

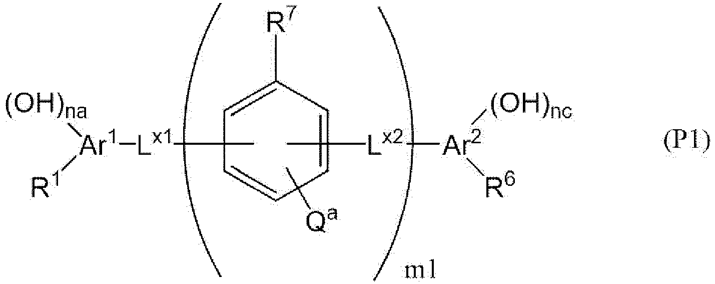

In General Formula (P1), m1 represents an integer of 0 or greater.

m1 is preferably 0 to 10, more preferably 0 to 3, even more preferably 0 or 1, and particularly preferably 1.

In General Formula (P1), na and nc each independently represent an integer of 1 or greater.

na and nc are each independently preferably 1 to 4.

In General Formula (P1), R¹ and R⁶ each independently represent a hydrogen atom, a halogen atom, a carboxylic acid group, a boronic acid group, an aldehyde group, an alkyl group, an alkoxy group, or an alkoxycarbonyl group.

The alkyl group may be linear or branched. The number of carbon atoms in the alkyl group is preferably 1 to 10. The alkyl group may or may not have a substituent.

An alkyl group moiety in the alkoxy group and an alkyl group moiety in the alkoxycarbonyl group are the same as the aforementioned alkyl group.

R¹ and R⁶ are each independently preferably a hydrogen atom or a halogen atom, more preferably a hydrogen atom or a chlorine atom, and even more preferably a hydrogen atom.

In General Formula (P1), R⁷ represents a hydrogen atom or a hydroxyl group.

In a case where there are a plurality of R⁷'s, the plurality of R⁷'s may be the same as or different from each other.

In a case where there are the plurality of R⁷'s, at least one R⁷ among the plurality of R⁷'s preferably represents a hydroxyl group.

In General Formula (P1), L^{x1} represents a single bond, -C(R²)(R³)-, or -CO-, and is preferably -C(R²)(R³)- or -CO-.

L^{x2} represents a single bond, -C(R⁴)(R⁵)-, or -CO-, and preferably represents -C(R⁴)(R⁵)- or -CO-.

R² to R⁵ each independently represent a hydrogen atom or a substituent.

The substituents are each independently preferably a hydroxyl group, a phenyl group, a halogen atom, a carboxylic acid group, a boronic acid group, an aldehyde group, an alkyl group, an alkoxy group, or an alkoxycarbonyl group, and more preferably a hydroxyl group, a halogen atom, a carboxylic acid group, a boronic acid group, an aldehyde group, an alkyl group, an alkoxy group, or an alkoxycarbonyl group.

The alkyl group may be linear or branched. The number of carbon atoms in the alkyl group is preferably 1 to 10. The alkyl group may or may not have a substituent.

An alkyl group moiety in the alkoxy group and an alkyl group moiety in the alkoxycarbonyl group are the same as the aforementioned alkyl group.

The phenyl group may or may not have a substituent, and in a case where the phenyl group has a substituent, the phenyl group more preferably has one to three hydroxyl groups.

R² to R⁵ are each independently preferably a hydrogen atom or a hydroxyl group, and more preferably a hydrogen atom.

L^{x1} and L^{x2} is each independently preferably -CH₂-, -CH(OH)-, -CO-, or -CH(Ph)-.

The Ph represents a phenyl group which may have a substituent.

In General Formula (P1), in a case where there are a plurality of R⁴'s, the plurality of R⁴'s may be the same as or different from each other. In a case where there are a plurality of R⁵'s, the plurality of R⁵'s may be the same as or different from each other.

In General Formula (P1), Ar¹ and Ar² each independently represent a benzene ring group or a naphthalene ring group.

Ar¹ and Ar² are each independently preferably a benzene ring group.

In General Formula (P1), Q^{a} represents a hydrogen atom, an alkyl group, a phenyl group, a halogen atom, a carboxylic acid group, a boronic acid group, an aldehyde group, an alkoxy group, or an alkoxycarbonyl group.

The alkyl group may be linear or branched. The number of carbon atoms in the alkyl group is preferably 1 to 10. The alkyl group may or may not have a substituent.

An alkyl group moiety in the alkoxy group and an alkyl group moiety in the alkoxycarbonyl group are the same as the aforementioned alkyl group.

The phenyl group may or may not have a substituent.

Q^{a} is preferably bonded to a para position with respect to a hydroxyl group that a benzene ring group, to which Q^{a} is bonded, may have.

Q^{a} is preferably a hydrogen atom or an alkyl group. The alkyl group is preferably a methyl group.

In General Formula (P1), in a case where there are a plurality of R⁷'s, L^{x2}'s and/or Q^{a}'s, the plurality of R⁷'s, L^{x2}'s, and/or Q^{a}'s may be the same as or different from each other.

Examples of the phenolic compound other than the phenolic compound represented by General Formula (P1) include benzene polyol such as benzenetriol, a biphenyl aralkyl-type phenolic resin, a phenol novolac resin, a cresol novolac resin, an aromatic hydrocarbon formaldehyde resin-modified phenolic resin, a dicyclopentadiene phenol addition-type resin, a phenol aralkyl resin, a polyhydric phenol novolac resin synthesized from a polyhydric hydroxy compound and formaldehyde, a naphthol aralkyl resin, a trimethylolmethane resin, a tetraphenylolethane resin, a naphthol novolac resin, a naphthol phenol co-condensed novolac resin, a naphthol cresol co-condensed novolac resin, a biphenyl-modified phenolic resin, a biphenyl-modified naphthol resin, an aminotriazine-modified phenolic resin, and an alkoxy group-containing aromatic ring-modified novolac resin.

A lower limit value of the hydroxyl group content of the phenolic compound is preferably 3.0 mmol/g or greater, and more preferably 7.0 mmol/g or greater. An upper limit value thereof is preferably 25.0 mmol/g or less, and more preferably 20.0 mmol/g or less.

The hydroxyl group content means a number of hydroxyl groups (preferably, phenolic hydroxyl groups) contained in 1 g of the phenolic compound.

In addition, the phenolic compound may have an active hydrogen-containing group (carboxylic acid group) capable of polymerizing with an epoxy compound, in addition to the hydroxyl group. A lower limit value of the content (total content of hydrogen atoms in an active hydrogen-containing group such as hydroxyl group and carboxylic acid group) of an active hydrogen atom in the phenolic compound is preferably 3.0 mmol/g or greater, and more preferably 7.0 mmol/g or greater. An upper limit value thereof is preferably 25.0 mmol/g or less, and more preferably 20.0 mmol/g or less.

The content of the active hydrogen atom means a number of active hydrogen atoms contained in 1 g of the phenolic compound.

An upper limit value of the molecular weight of the phenolic compound is preferably 600 or less, more preferably 500 or less, even more preferably 450 or less, and particularly preferably 400 or less. A lower limit value thereof is preferably 110 or greater, and more preferably 300 or greater.

One kind of the phenolic compounds may be used singly, or two or more kinds thereof may be used.

The composition contains the phenolic compound. A content of the phenolic compound is preferably 1.0% by mass or greater, more preferably 3.0% to 25.0% by mass, and even more preferably 5.0% to 20.0% by mass, with respect to the total solid content of the composition.

The composition contains an epoxy compound and a phenolic compound. A ratio of the number of phenolic hydroxyl groups of the phenolic compound to the number of epoxy groups of the epoxy compound (the number of phenolic hydroxyl groups of the phenolic compound/the number of the epoxy groups of the epoxy compound) is preferably 0.50 to 2.00, more preferably 0.65 to 1.50, and even more preferably 0.80 to 1.20.

A ratio of the content of the epoxy compound to the phenolic compound in the composition is preferably such that the aforementioned "number of phenolic hydroxyl groups/number of epoxy groups" is within the above range.

In addition, in the composition, a ratio (total number of active hydrogen atoms contained in solid content/total number of the number of epoxy groups contained in the solid content) of the total number of active hydrogen atoms (hydrogen atoms of the phenolic hydroxyl group) contained in the solid content to the total number of the number of epoxy groups contained in the solid content is preferably 0.50 to 2.00, more preferably 0.65 to 1.50, and even more preferably 0.80 to 1.20.

A content of the thermosetting compound A in the composition is 10% to 40% by mass, with respect to the total solid content of the composition.

In addition, a total content of the epoxy compound and the phenolic compound is preferably 30% to 100% by mass, more preferably 70% to 100% by mass, and even more preferably 90% to 100% by mass with respect to the total mass of the thermosetting compound A.

### [Boron Nitride Particles]

The composition according to the embodiment of the present invention contains boron nitride (BN) and boron nitride particles B (hereinafter, also simply referred to as "particles B") having an average particle diameter of 25.0 µm or more.

In addition, the composition according to the embodiment of the present invention contains boron nitride, has an average particle diameter of 5.0 µm or less, has an oxygen atom concentration on a surface of 1.5% or more detected by X-ray photoelectron spectroscopic analysis, and contains boron nitride particles C (hereinafter, also referred to as "specific particles C").

By the composition containing the particles B, the thermally conductive properties of the thermally conductive material formed from the composition can be improved. In addition, since the composition contains specific particles C together with the particles B, it is possible to form a thermally conductive material having excellent adhesiveness while maintaining excellent thermally conductive properties.

Hereinafter, each of the particles B and the specific particles C will be described.

In addition, in the present specification, the boron nitride particles C containing boron nitride and having an average particle diameter of 5.0 µm or less is also simply referred to as "particles C". That is, the specific particles C is one aspect of the particles C.

### <Particles B>

A content of boron nitride contained in the particles B is not particularly limited, but is preferably 50% by mass or more, more preferably 80% by mass or more, and even more preferably 90% by mass or more, with respect to the total mass of the particles B. The particles B may be particles composed of only boron nitride. That is, a content of boron nitride in the particles B may be 100% by mass or less.

An average particle diameter of the particles B is preferably 30.0 µm or more, more preferably 32.0 µm or more, even more preferably 38.0 µm or more, and particularly preferably 40.0 µm or more, in that the thermally conductive properties of the thermally conductive material are more excellent.

An upper limit of the average particle diameter of particles B is not particularly limited, but from the viewpoint that the dispersibility of the composition is more excellent, the upper limit of the average particle diameter of the particles B is preferably 500.0 µm or less, more preferably 300.0 µm or less, and even more preferably 200.0 µm or less.

In a case where a commercially available product is used, for the average particle diameter of the particles B and the particles C described later, a catalog value is adopted. In a case where there is no catalog value, the average particle diameter is obtained by randomly selecting 100 pieces of inorganic substances using an electron microscope, measuring particle diameter (long diameter) of each of the particles, and calculating an arithmetic mean thereof.

A shape of the particles B is not particularly limited, and may be any of a scale shape, a flat plate shape, a rice grain shape, a spherical shape, a cubical shape, a spindle shape, an aggregation shape, and an amorphous shape.

One kind of the particles B may be used singly, or two or more kinds thereof may be used.

A content of the particles B in the composition is preferably 40% to 95% by mass, more preferably 50% to 90% by mass, and even more preferably 65% to 85% by mass, with respect to the total solid content of the composition, from the viewpoint of more excellent balance between the thermally conductive properties and the adhesiveness of the thermally conductive material.

### <Specific particles C>

A content of boron nitride contained in the specific particles C is not particularly limited, but is preferably 50% by mass or more, more preferably 80% by mass or more, and even more preferably 90% by mass or more, with respect to the total mass of the specific particles C. The content of boron nitride in the specific particles C is not particularly limited, but is preferably 99.9% by mass or less, and more preferably 99.5% by mass or less.

An oxygen atom concentration on a surface of the boron nitride particles is measured as follows. That is, the boron nitride particles are measured by an X-ray photoelectron spectrometer (XPS) (AXIS-HS: produced by Shimadzu/KRATOS) at a scanning speed of 20 eV/min (0.1 eV step). As the detailed measurement conditions, monochrome Al (tube voltage; 15 kV, tube current; 15 mA) is used as the X-ray source, the lens conditions are HYBRID (analysis area; 600 µm × 1000 µm), and the resolution is Pass Energy 40. The peak surface area values of oxygen atom, nitrogen atom, boron atom, and carbon atom obtained by the measurement are corrected by the sensitivity coefficient of each element. The oxygen atom concentration on the surface of the boron nitride particles can be measured by obtaining the ratio of the number of atoms of the oxygen atom to the corrected total amount of oxygen atom, nitrogen atom, boron atom, and carbon atom.

As a method of correcting the peak surface area values of oxygen atom, nitrogen atom, boron atom, and carbon atom obtained by the measurement by the sensitivity coefficient of each element, specifically, for oxygen atom, a peak surface area value of 537 eV from 528 eV is divided by the sensitivity coefficient 0.780 for the oxygen atom, for nitrogen atom, a peak surface area value of 402 eV from 395 eV is divided by the sensitivity coefficient 0.477 for the nitrogen atom, for boron atom, a peak surface area value of 194 eV from 188 eV is divided by the sensitivity coefficient 0.159 for the boron atom, and for carbon atom, a peak surface area value of 289 eV from 282 eV is divided by the sensitivity coefficient 0.278 for the carbon atom.

An oxygen atom concentration on the surface of the specific particles C detected by X-ray photoelectron spectroscopic analysis is 1.5 atomic% or more. From a viewpoint of more excellent adhesiveness of the thermally conductive material, the oxygen atom concentration on the surface of the specific particle C is preferably 1.5 atomic% or more, more preferably 2.0 atomic% or more, and even more preferably 2.4 atomic% or more. The upper limit of the oxygen atom concentration on the surface of the specific particles C is not particularly limited, but from the viewpoint of maintaining the shape of the surface of the specific particles C and more excellent thermally conductive properties of the thermally conductive material, the oxygen atom concentration is preferably 30 atomic% or less, more preferably 28 atomic% or less, and even more preferably 25 atomic% or less.

### (Surface treatment method)

A method for producing the specific particles C is not particularly limited, and examples thereof include a method of performing treatment such as plasma treatment, ultraviolet (UV) treatment, ozone treatment, and chromic acid treatment on the particles C, and improving the oxygen atom concentration on the surface of the particles C.

Examples of the plasma treatment include a method of treating boron nitride particles in a plasma atmosphere in a dry environment, plasma treatment in gas of dispersing boron nitride particles in a solution, generating plasma above the liquid surface, introducing an active species in liquid, and treating thereof, aqua plasma treatment of directly or indirectly treating the surface of boron nitride particles by low-temperature plasma generated in a case of applying a high voltage of bipolar kV unit with a pulse width of several tens of kHz microseconds in liquid in which boron nitride particles are dispersed. Among them, aqua plasma treatment is preferable.

As a plasma treatment liquid used in a case of performing aqua plasma treatment on boron nitride particles, distilled water, purified water such as deionized water, and an aqueous solution obtained by adding an electrolyte to pure water are effective. Examples of the electrolyte include sodium chloride and potassium chloride, and sodium chloride is preferable. A content of the electrolyte in the plasma treatment liquid is preferably 0.001% to 10% by mass, more preferably 0.001% to 0.1% by mass, and even more preferably 0.005% to 0.02% by mass with respect to the total amount of the plasma treatment liquid.

A content of the boron nitride particles in the plasma treatment liquid is preferably 10% by mass or less, and more preferably 1% to 5% by mass, with respect to the plasma treatment liquid not containing boron nitride particles.

The plasma treatment time is preferably 0.5 to 3 hours, and more preferably 1 hour.

A pulse frequency of the plasma treatment is preferably 10 to 100 kHz, and more preferably 70 to 90 kHz.

The applied voltage of the plasma treatment is preferably 1 to 10 kV, and more preferably 1 to 3 kV.

The pulse width of the plasma treatment is preferably 0.1 to 4 µsec, and more preferably 0.6 to 9 µsec.

As a UV treatment method for the boron nitride particles, a UV treatment technology used in a technology of producing various chemical products can be applied. Examples of the UV irradiation device used in the UV treatment technology include a high-pressure mercury lamp, a low-pressure mercury lamp, a deuterium lamp, a metal halide lamp, a xenon lamp, and a halogen lamp.

The UV used for irradiation preferably includes light including an ultraviolet region having a wavelength of 150 to 400 nm, and more preferably includes light having a wavelength of 150 to 300 nm from the viewpoint of activating the surface of the boron nitride particles.

The UV irradiation intensity is not particularly limited, but is preferably 0.5 mW/cm² or more. With this irradiation intensity, there is a tendency that a targeted effect is more sufficiently exhibited. In addition, 100 mW/cm² or less is preferable. With this irradiation intensity, there is a tendency that damage to the boron nitride particles due to UV irradiation can be further suppressed. The UV irradiation intensity is preferably 0.5 to 100 mW/cm², and more preferably 1 to 20 mW/cm².

The irradiation time is preferably 10 seconds or longer. In addition, from the viewpoint of suppressing damage to the boron nitride particles due to UV irradiation, 30 minutes or less is preferable.

An irradiation amount of ultraviolet rays is preferably 100 mJ/cm² or more, more preferably 1,000 mJ/cm² or more, even more preferably 5,000 mJ/cm² or more, and particularly preferably 10,000 mJ/cm² or more. In addition, from the viewpoint of further suppressing damage to the boron nitride particles due to UV irradiation, 50,000 mJ/cm² or less is preferable.

In a case of irradiating the boron nitride particles with ultraviolet rays, it is preferable to irradiate the boron nitride particles with ultraviolet rays as uniformly as possible. Examples of a method of making the irradiation uniform include a method of irradiating ultraviolet rays while stirring the boron nitride particles. For stirring the boron nitride particles during UV irradiation, any of a method of stirring with a stirring rod, a spatula, or a drug spoon, a method of using a stirring device such as a method of stirring by vibrating a container into which the boron nitride particles are put, and a method not using a stirring device such as a vibration type mixer, a ribbon type mixer, or a paddle type mixer during UV irradiation can be applied. From the viewpoint of uniform mixing, it is preferable to use a stirring device, and it is more preferable to use a stirring device such as a paddle type mixer.

In addition, the atmosphere in the UV treatment is not limited, but from the viewpoint of improving the oxygen atom concentration on the surface of the boron nitride particles, the atmosphere is preferably in the presence of oxygen such as under the atmosphere, or in the presence of ozone.

It is considered that by subjecting the boron nitride particles to the UV treatment, the oxygen atom concentration on the surface of the boron nitride particles is increased and a B-O bond is generated. In addition, it is considered that B-OH (hydroxyl group) is generated in addition to the generation of the B-O bond at a terminal portion in which the B-O bond is generated, and as a result, hydrophilicity of the surface of the boron nitride particles is improved.

From the viewpoint of more excellent adhesiveness of the thermally conductive material, a contact angle of the specific particles C is preferably less than 70°, more preferably less than 60°, even more preferably less than 50°, and particularly preferably less than 30°. A lower limit is not particularly limited, but from the viewpoint of thermal conductivity of particles, the lower limit is preferably 5° or more.

The contact angle of particles such as specific particle C is measured by a liquid droplet method.

Specifically, a flat plate-shaped tablet made of particles is molded, water is dropped on the surface of the obtained flat sample, and an angle between the sample and on a side containing water is measured as the contact angle.

How to obtain the contact angle by such a liquid drop method is described in "Wettability and Control" (Technical Information Institute Co., Ltd., published on January 31, 2001), for example.

The contact angle of the liquid droplet on the sample surface may be measured by using a known measuring device, and examples of the measuring device of the contact angle include a contact angle meter (DropMaster DM500 produced by Kyowa Interface Science Co., Ltd.).

In addition, the molding of a tablet made of particles can be performed by compressing the particles for 5 minutes at pressure of 500 kgf/cm² using a known tablet molding device.

The average particle diameter of the specific particles C is 5.0 µm or less, from the viewpoint of more excellent adhesiveness of the thermally conductive material, preferably 4.5 µm or less, particularly preferably less than 4.0 µm, and most preferably 3.5 µm or less.

A lower limit of the average particle diameter of the specific particles C is not particularly limited, but is preferably 0.3 µm or more, and, from the viewpoint of more excellent adhesiveness of the thermally conductive material, is more preferably 1.0 µm or more, even more preferably more than 2.0 µm, and particularly preferably 2.5 µm or more.

A shape of the specific particles C is not particularly limited, and may be any of a scale shape, a flat plate shape, a rice grain shape, a spherical shape, a cubical shape, a spindle shape, an aggregation shape, and an amorphous shape.

One kind of the specific particles C may be used singly, or two or more kinds thereof may be used.

A content of the specific particles C in the composition is preferably 3% to 30% by mass, more preferably 3% to 20% by mass, and even more preferably 3% to 10% by mass, with respect to the total solid content of the composition, from the viewpoint of more excellent balance between the thermally conductive properties and the adhesiveness of the thermally conductive material.

In the composition, from the viewpoint of more excellent balance between the thermally conductive properties and adhesiveness of the thermally conductive material, a content of the particles B with respect to the total content of the particles B and the specific particles C is 70% to 95% by mass, preferably 85% to 95% by mass, and more preferably 85% to 95% by mass.

### [Curing accelerator]

The composition may further contain a curing accelerator.

Examples of the curing accelerator include triphenylphosphine, a boron trifluoride-amine complex, and the compound described in paragraph 0052 of JP2012-067225A. In addition to the aforementioned curing accelerators, examples thereof include imidazole-based curing accelerator such as 2-methylimidazole (trade name; 2MZ), 2-undecylimidazole (trade name; C11-Z), 2-heptadecylimidazole (trade name; C17Z), 1,2-dimethylimidazole (trade name; 1.2DMZ), 2-ethyl-4-methylimidazole (trade name: 2E4MZ), 2-phenylimidazole (trade name; 2PZ), 2-phenyl-4-methylimidazole (trade name; 2P4MZ), 1-benzyl-2-methylimidazole (trade name; 1B2MZ), 1-benzyl-2-phenylimidazole (trade name; 1B2PZ), 1-cyanoethyl-2-methylimidazole (trade name; 2MZ-CN), 1-cyanoethyl-2-undecylimidazole (trade name; C11Z-CN), 1-cyanoethyl-2-phenylimidazolium trimellitate (trade name; 2PZCNS-PW), 2,4-diamino-6-[2'-methylimidazolyl-(1')]-ethyl-s-triazine (trade name; 2MZ-A), 2,4-diamino-6-[2'-undecylimidazolyl-(1')]-ethyl-s-triazine (trade name; C11Z-A), 2,4-diamino-6-[2'-ethyl-4'-methylimidazolyl-(1')]-ethyl-s-triazine (trade name; 2E4MZ-A), 2,4-diamino-6-[2'-methylimidazolyl-(1')]-ethyl-s-triazine isocyanuric acid adduct (trade name; 2MA-OK), 2-phenyl-4,5-dihydroxymethylimidazole (trade name; 2PHZ-PW), 2-phenyl-4-methyl-5-hydroxymethylimidazole (trade name; 2P4MHZ-PW), 1-cyanoethyl-2-phenylimidazole (trade name; 2PZ-CN), 2,4-diamino-6-[2'-methylimidazolyl-(1')]-ethyl-s-triazine (trade name; 2MZA-PW), and 2,4-diamino-6-[2'-methylimidazolyl-(1')]-ethyl-s-triazine isocyanuric acid adduct (trade name; 2MAOK-PW) (all produced by SHIKOKU CHEMICALS CORPORATION).

One kind of the curing accelerators may be used singly, or two or more kinds thereof may be used.

In a case where the composition contains the curing accelerator, a content of the curing accelerator is preferably 0.01% to 10% by mass, and more preferably 0.1% to 5% by mass, with respect to the total content of the phenolic compound and the epoxy compound.

### [Dispersant]

The composition may further contain a dispersant.

In a case where the composition contains a dispersant, the dispersibility of the inorganic substance in the composition is improved, and thus more excellent thermal conductivity and adhesiveness can be realized.

The dispersant can be appropriately selected from known dispersants. Examples thereof include DISPERBYK-106 (produced by BYK-Chemie GmbH), DISPERBYK-111 (produced by BYK-Chemie GmbH), ED-113 (produced by Kusumoto Chemicals, Ltd.), AJISPER PN-411 (produced by Ajinomoto Fine-Techno Co., Inc.), and REB122-4 (produced by Showa Denko Materials Co., Ltd.).

One kind of the dispersants may be used singly, or two or more kinds thereof may be used.

In a case where the composition contains a dispersant, a content of the dispersant is preferably 0.01% to 10% by mass, and preferably 0.1% to 5% by mass, with respect to the content of the particles B, the specific particles C, and the inorganic substances described later.

### [Other fillers]

The composition may contain other fillers in addition to the above-mentioned particles B and specific particles C. Examples of other fillers include an inorganic substance (inorganic filler) and an organic substance (organic filler) that has been used as a filler of the thermally conductive material in the related art.

Among them, an inorganic substance is preferable, and an inorganic oxide or inorganic nitride (here, excluding particles B and specific particles C) is more preferable.

A shape of the other fillers is not particularly limited, and may be a granule shape, may be a film shape, or may be a plate shape. Examples of the shape of the granule filler include a rice grain shape, a spherical shape, a cubical shape, a spindle shape, a scale shape, an aggregation shape, and an amorphous shape.

A size of the other fillers is not particularly limited, but from the viewpoint of more excellent dispersibility, an average particle diameter of the other fillers is preferably 500 µm or less, more preferably 300 µm or less, and even more preferably 200 µm or less. A lower limit thereof is not particularly limited, but is preferably 10 nm or greater, and more preferably 100 nm or greater, from the viewpoint of handleability.

The average particle diameter of the other fillers can be obtained in the same manner as the average particle diameter of the particles B and the specific particles C.

One kind of the other fillers may be used singly, or two or more kinds thereof may be used.

The total content of the fillers (the particles B, the specific particles C, and the other fillers) in the composition is preferably 40% to 95% by mass, more preferably 50% to 95% by mass, and even more preferably 65% to 95% by mass, with respect to the total solid content of the composition.

### [Surface modifier]

The composition may contain a surface modifier.

The surface modifier is a component that surface-modifies an inorganic substance (for example, an inorganic nitride (including particles B and specific particles C) and an inorganic oxide). That is, the particles B and the specific particles C may be surface-modified with a surface modifier as long as the oxygen atom concentration on the surface is within the above range.

In the present specification, "surface modification" means a state in which an organic substance is adsorbed onto at least a part of a surface of the inorganic substance. A form of the adsorption is not particularly limited, and may be in a bonded state. That is, the surface modification also includes a state in which an organic group obtained by desorbing a part of the organic substance is bonded to the surface of the inorganic substance. The bond may be any one of a covalent bond, a coordinate bond, an ionic bond, a hydrogen bond, a van der Waals bond, or a metallic bond. The surface modification may be performed so that a monolayer is formed on at least a part of the surface. The monolayer is a single-layer film formed by chemical adsorption of organic molecules, and is known as a self-assembled monolayer (SAM). Moreover, in the present specification, the surface modification may be performed only on a part of the surface of the inorganic substance, or may be performed on the entire surface thereof.

**In** the composition, the inorganic substance (including the particles B and the specific particles C) may form a surface-modified inorganic substance in cooperation with the surface modifier.

The method for producing the surface-modified inorganic substance is not particularly limited, and examples thereof include a method including a step of bringing the inorganic substance into contact with the surface modifier. The contact between the inorganic substance and the surface modifier is carried out, for example, by stirring in a mixed solution of the inorganic substance, the surface modifier and the organic solvent.

**In** addition, the surface-modified inorganic substance may be separately prepared and then the prepared surface-modified inorganic substance may be mixed with a part or all of another raw material in the composition.

One kind of the surface modifier may be used singly, or two or more kinds thereof may be used.

In a case where the composition contains a surface modifier, a mass ratio of the content of the surface modifier to the content of the inorganic substance containing the particles B and the specific particles C (the content of the surface modifier/content of inorganic substance) is preferably 0.00001 to 0.5, and more preferably 0.0001 to 0.1, from the viewpoint of more excellent dispersibility of the inorganic substance.

### [solvent]

The composition may further contain a solvent.

A kind of the solvent is not particularly limited, and an organic solvent is preferable. Examples of the organic solvent include cyclopentanone, cyclohexanone, ethyl acetate, methyl ethyl ketone, dichloromethane, and tetrahydrofuran.

In a case where the composition contains a solvent, a content of the solvent is preferably an amount such that the concentration of the solid content in the composition is 20% to 90% by mass, more preferably an amount such that the concentration is 30% to 85% by mass, and even more preferably an amount such that the concentration is 40% to 85% by mass.

### [Method of preparing composition]

A method of preparing the composition is not particularly limited, known methods can be adopted, and for example, the composition can be prepared by mixing the aforementioned various components. In a case of mixing, the various components may be mixed at a time, or may be mixed sequentially.

A method of mixing the components is not particularly limited, and known methods can be used. A mixing device used for mixing is preferably a disperser in liquid. Examples of the disperser in liquid include a rotating and revolving mixer, a stirrer such as a high-speed rotating shear-type stirrer, a colloid mill, a roll mill, a high-pressure injection-type disperser, an ultrasonic disperser, a beads mill, and a homogenizer.

One kind of the mixing devices may be used singly, or two or more kinds thereof may be used. A deaeration treatment may be performed before and after the mixing and/or simultaneously with the mixing.

### [Method of curing composition]

By curing the composition, a thermally conductive material is obtained.

A method of curing the composition is not particularly limited, but a thermal curing reaction is preferable.

A heating temperature during the thermal curing reaction is not particularly limited. For example, the heating temperature may be appropriately selected within a range of 50°C to 250°C. In addition, in a case where the thermal curing reaction is performed, a heating treatment at different temperatures may be performed a plurality of times.

The curing treatment is preferably performed on the composition which is formed in a film shape or a sheet shape. More specifically, it is preferable to apply the composition to form a film, and then to perform curing treatment on the obtained coating film.

In a case where the curing treatment is performed, it is preferable to apply the composition onto a substrate to form a coating film, and then to cure the coating film. In this case, a different substrate is further brought into contact with the coating film formed on the substrate, and then the curing treatment may be performed. A cured substance (thermally conductive material) obtained after the curing may or may not be separated from one or both of the substrates.

In addition, in a case where the curing treatment is performed, the composition is applied onto different substrates to form respective coating films, and the curing treatment may be performed in a state where the obtained coating films are in contact with each other. A cured substance (thermally conductive material) obtained after the curing may or may not be separated from one or both of the substrates.

At a time of the curing treatment, press working may be performed. A press used for press working is not limited, and for example, a flat plate press may be used, or a roll press may be used.

In a case where the roll press is used, for example, preferably, a substrate with a coating film, which is obtained by forming a coating film on a substrate, is sandwiched between a pair of rolls in which two rolls face each other, and while rotating the pair of rolls to cause the substrate with a coating film to be passed, a pressure is applied in a film thickness direction of the substrate with a coating film. In the substrate with a coating film, a substrate may be present on only one surface of the coating film, or a substrate may be present on both surfaces of the coating film. The substrate with a coating film may be passed through the roll press only once or a plurality of times.

Only one of the treatment by the flat plate press and the treatment by the roll press may be carried out, or both may be carried out.

In addition, the curing treatment may be completed at a time at which the composition is in a semi-cured state. The thermally conductive material in a semi-cured state may be arranged so as to be in contact with the device to be used, then further cured by treatment such as heating, and the main curing may be performed. An aspect in which the device and the thermally conductive material adhere to each other by treatment such as heating at the time of the main curing is also preferable.

For the preparation of the thermally conductive material including a curing reaction, "Highly Thermally Conductive Composite Material" (CMC Publishing CO., LTD., written by Yoshitaka TAKEZAWA) can be referred to.

A shape of the thermally conductive material is not particularly limited, and the thermally conductive material can be molded into various shapes depending on the use. Examples of a typical shape of the molded thermally conductive material include a sheet shape.

That is, it is also preferable that the thermally conductive material obtained by using the composition is a thermally conductive sheet.

In addition, the thermally conductive properties of the thermally conductive material obtained by using the composition are preferably isotropic rather than anisotropic.

The thermally conductive material preferably has insulating properties (electrical insulating properties). In other words, the composition is preferably a thermally conductive insulating composition.

For example, a volume resistivity of the thermally conductive material at 23°C and a relative humidity of 65% is preferably 10¹⁰ Ω·cm or greater, more preferably 10¹² Ω·cm or greater, and even more preferably 10¹⁴ Ω·cm or greater. An upper limit thereof is not particularly limited, but is generally 10¹⁸ Ω·cm or less.

The composition and/or physical properties of each component contained in the thermally conductive material may be measured by a known method in the related art. For example, other members that come into contact with the thermally conductive material are peeled off, and then the thermally conductive material is fired at a temperature of 200° C to 500°C to decompose the resin, the filler is taken out, and then by measuring the aforementioned average particle diameter and measuring the oxygen atom concentration, with respect to the taken-out filler, an average particle diameter and an oxygen atom concentration of the filler such as boron nitride particles contained in the thermally conductive material are obtained.

### [Use of thermally conductive material]

The thermally conductive material obtained by using the composition can be used as a heat dissipation material such as a heat dissipation sheet, and can be used for dissipating heat from various devices. More specifically, a device with a thermally conductive layer is prepared by arranging a thermally conductive layer, which contains the thermally conductive material on a device, and thus the heat generated from the device can be efficiently dissipated by the thermally conductive layer.

The thermally conductive material obtained by using the composition has sufficient thermally conductive properties and high heat resistance, and thus is suitable for dissipating heat from a power semiconductor device used in various electrical machines such as a personal computer, a general household electric appliance, and an automobile.

In addition, the thermally conductive material obtained by using the composition has sufficient thermally conductive properties even in a semi-cured state, and thus can also be used as a heat dissipation material which is arranged in a portion where light for photocuring is hardly reached, such as a gap between members of various devices. In addition, the thermally conductive material also has excellent adhesiveness, and thus can also be used as an adhesive having thermally conductive properties.

The thermally conductive material obtained by using the composition may be used in combination with members other than the members formed of the composition.

For example, a sheet-shaped thermally conductive material (thermally conductive sheet) may be combined with a sheet-shaped support in addition to the layer formed of the composition.

Examples of the sheet-shaped support include a plastic film, a metal film, and a glass plate. Examples of a material for the plastic film include polyester such as polyethylene terephthalate (PET), polycarbonate, an acrylic resin, an epoxy resin, polyurethane, polyamide, polyolefin, a cellulose derivative, and silicone. Examples of the metal film include a copper film.

A film thickness of the sheet-shaped thermally conductive material (thermally conductive sheet) is not particularly limited, and is preferably 100 to 300 µm and more preferably 150 to 250 µm.

### Examples

Hereinafter, the present invention will be described in more detail based on Examples. The materials, the use amount, the proportion, the details of treatments, the procedure of treatments, shown in the following Examples can be appropriately changed within a range that does not depart from the present invention. Accordingly, the scope of the present invention is not limitedly interpreted by the following Examples.

### [Composition for forming a thermally conductive material]

Hereinafter, various components in the composition for forming a thermally conductive material (composition) used for preparing the thermally conductive material prepared in Examples and Comparative Examples are shown.

### <Phenolic compound>

Phenolic compounds used in Examples or Comparative Examples will be shown below.

The compounds A-1 and A-2 correspond to the compounds represented by General Formula (P1).

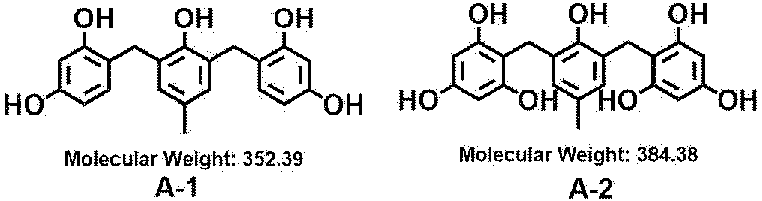

### <Epoxy compound>

Epoxy compounds used in Examples or Comparative Examples will be shown below.

In addition, the B-3 is a mixture of two kinds of epoxy compounds (trade name: EPOTOHTO ZX-1059, produced by Tohto Chemical Industry Co., Ltd.).

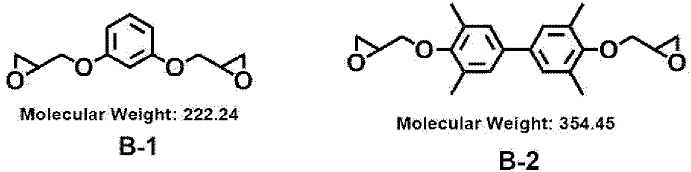

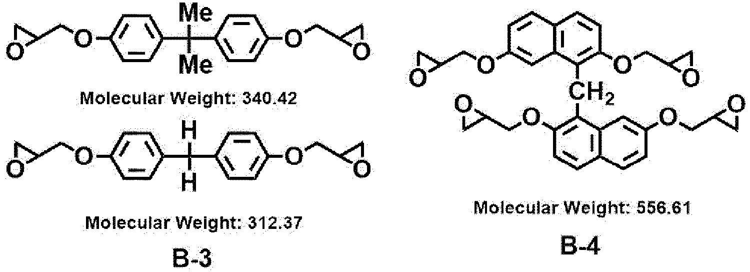

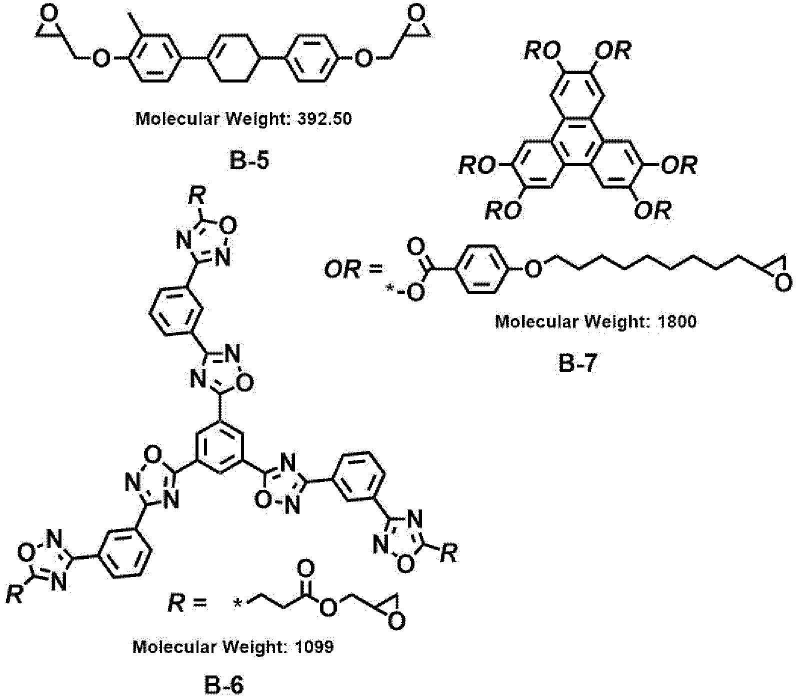

### <Particles B>

The particles B (boron nitride particles B) used in each Example or each Comparative Example are shown below.
· HP40 MF-100: Aggregation-shaped boron nitride particles produced by Mizushima Ferroalloy Co., Ltd.
· PCTP30: Flat plate-shaped boron nitride particles produced by Saint-Gobain Co., Ltd.

### <Specific particles C>

The particles C (boron nitride particles C) used in each Example or each Comparative Example are shown below.
· SP-2: Produced by Denka Company Limited, scale shape
· SP-3: Produced by Denka Company Limited, scale shape
· SP3-7: Produced by Denka Company Limited, scale shape
· MNB-010T: Produced by Mitsui Chemicals, Inc., flat plate shape
· HGP: Produced by Denka, flat plate shape
· UHP-2: Produced by Showa Denko K. K., scale shape
· UHP-1K: Produced by Showa Denko K. K., scale shape

The particles C were subjected to the surface treatment shown below to produce the specific particles C used in each Example or each Comparative Example.

### (Plasma treatment 1)

Particles C were added to an aqueous solution containing sodium chloride to prepare a dispersion liquid containing the particles C. After putting the obtained dispersion in a beaker, a plasma generation electrode was inserted, and a plasma treatment of applying a high frequency pulse voltage to generate plasma was performed for 60 minutes under the following plasma treatment conditions. After the plasma treatment, the obtained dispersion was filtered and separated into a filtrate and a filtration product. The collected powders (the filtration product) were vacuum-dried to obtain specific particles C.

### - Plasma treatment conditions -

Current/voltage conditions
· Voltage application frequency: 80 kHz
· Peak voltage: ± 2kV
· Peak current: + 4A
· Pulse width: 0.5 µsec
· Distance between electrodes: 3.8 mm
· Dispersion medium: 0.01% by mass sodium chloride aqueous solution 70 mL
· Stirring speed: 400 rpm
· Plasma treatment time: 60 minutes

### (Plasma treatment 2)

Specific particles C were produced by subjecting the surface of the particles C to plasma treatment according to the method described in (plasma treatment 1) above, except that the plasma treatment time under the plasma treatment conditions was changed to 5 minutes.

### (Plasma treatment 3)

Specific particles C were produced by subjecting the surface of the particles C to plasma treatment according to the method described in (plasma treatment 1) above, except that the plasma treatment time under the plasma treatment conditions was changed to 30 minutes.

### (UV treatment)

The specific particles C were produced by putting the particles C in a container and irradiating the particles C with ultraviolet rays for 10 minutes using a 200 W low-pressure mercury lamp while stirring the particles C.

The irradiation intensity of ultraviolet rays was obtained as an average irradiation intensity of 254 nm light by measuring the amount of light of 254 nm with an ultraviolet integrated photometer (USHIO UIT-150). More specifically, the irradiation intensity of ultraviolet rays from a low-pressure mercury lamp was measured using an ultraviolet integrated photometer, and a value displayed on the photometer was recorded every 10 seconds. The sum of the values recorded thereafter was divided by the irradiation time of ultraviolet rays to obtain the average irradiation intensity. The obtained irradiation intensity of the ultraviolet rays was 15,000 mJ/cm².

### (Measurement of oxygen atom concentration)

The oxygen atom concentration on the surface of the specific particles C or the particles C was measured using an X-ray photoelectron spectrometer (AXIS-HS, produced by Shimadzu/KRATOS). The measurement conditions are shown below.
· Scanning speed: 20 eV/min
· X-ray source: Monochrome AI (tube voltage 15 kV, tube current 15 mA)
· Lens condition: HYBRID (analysis area 600 x 1,000 µm)
· Resolution: Pass Energy 40

Table 1 described later shows the oxygen atom concentration (unit: atomic%) on the surface of the specific particles C or the particles C used in each Example or each Comparative Example.

### (Measurement of contact angle)

The contact angle of the specific particles C or the particles C was measured by the following method.

The specific particles C or the particles C were pressed with a press machine (MP-WNL, produced by Toyo Seiki Seisaku-sho, Ltd.) at a pressure of 500 kgf/cm² to obtain pellets. The pellets were taken out, and the contact angle with water was measured with a contact angle measuring device (DropMaster DM500, produced by Kyowa Interface Science Co., Ltd.) at 25°C and 50% humidity.

Table 1 described later shows the contact angle (°) of the specific particles C or the particles C used in each Example or each Comparative Example.

### <Curing accelerator>

PPh₃ (triphenylphosphine) was used as a curing accelerator.

### <Solvent>

Cyclopentanone was used as the solvent.

### [Preparation of composition]

An epoxy compound and a phenolic compound combined shown in Table 1 below were formulated at an amount at which the number of epoxy groups and the number of phenolic hydroxyl groups in the system were equivalent to prepare a curing liquid.

After mixing the total amount of the obtained curing liquid, the solvent, and the curing accelerator in this order, particles B and specific particles C (or particles C for comparison) were added to obtain a mixture. The obtained mixture was treated for 5 minutes with a rotating and revolving mixer (AWATORI RENTARO ARE-310, produced by THINKY CORPORATION) to obtain a composition (composition for forming a thermally conductive material) of each Example or Comparative Example.

Here, an addition amount of the solvent was set such that the concentration of the solid content in the composition was 50% to 80% by mass. In addition, the concentration of the solid content in the composition was adjusted for each composition within the range such that the viscosities of the compositions were about the same.

In addition, an addition amount of the curing accelerator was set such that the content of the curing accelerator in the composition was 1% by mass with respect to a total content of the epoxy compound and the phenolic compound.

In addition, the particles B and the specific particles C (or the particles C) were added in an amount such that a formulated amount of the composition with respect to the total solid content was the amount shown in Table 1 below.

In Comparative Example 5, the composition was prepared by the same procedure as in other Examples or Comparative Examples, except that particles C modified with a surface modifier (hereinafter, also referred to as "surface-modified particles") were added as the particles C for comparison by the method described later.

The formulation of the solid content in the composition of each Example or Comparative Example is shown in Table 1.

### <<Production of surface-modified particles for comparison>>

3 g of a silane coupling agent "KBM-403" (3-glycidoxypropyltrimethoxysilane, produced by Shin-Etsu Chemical Co., Ltd.) was added to a dispersion medium CPO (250 mL, cyclopentanone) to obtain a mixed solution. The above SP-2 (100 g) was added to this mixed solution and stirred overnight to perform an adsorption treatment. After the adsorption treatment, the obtained slurry liquid was filtered and separated into a filtrate and a filtration product. The collected powders (the filtration product) were dried to obtain surface-modified particles modified with a silane coupling agent. From the difference between the absorption spectrum of the mixed solution before the addition of the surface-modified particles and the absorption spectrum of the filtrate after the adsorption treatment, the adsorption amount of the silane coupling agent per 1 g of the boron nitride particles was calculated as 20 mg.

### [Preparation of thermally conductive material]

### <Preparation of test specimen>

The composition having the formulation shown in Table 1 below of each Example and each Comparative Example was uniformly applied onto a release surface of a release-treated polyester terephthalate film (PET 756501, produced by Lintec Corporation, film thickness of 75 µm) (hereinafter, referred to as "PET film") by using an applicator, and left to stand at 120°C for 5 minutes to obtain a coating film.

Two PET films with such a coating film were prepared, and after attaching the two PET films with a coating film to coating film surfaces, the two PET films with a coating film were hot-pressed (treated at a hot plate temperature of 120°C and a pressure of 20 MPa for one minute) in the air to obtain a semi-cured film. The obtained semi-cured film was treated with a hot press in the air (treated at a hot plate temperature of 180°C and a pressure of 10 MPa for 5 minutes, and then further treated at normal pressure at 180°C for 90 minutes) to cure the semi-cured film, and a resin sheet was obtained.

The PET films on both surfaces of the resin sheet were peeled off to obtain a thermally conductive sheet of each Example or each Comparative Example, having an average film thickness of 200 µm.

### [Evaluation]

### <Evaluation of thermally conductive properties>

Using the thermally conductive sheet of each Example and each Comparative Example, the thermal conductivity was measured by the following method, and the thermally conductive properties were evaluated.

### (Measurement of thermal conductivity (W/m·k))

(1) Using "LFA467" produced by NETZSCH Japan K. K., the thermal diffusivity in a thickness direction of the thermally conductive sheet was measured by a laser flash method.
(2) The specific gravity of the thermally conductive sheet was measured by the Archimedes method (using the "solid specific gravity measuring kit") using the balance "XS204" produced by Metler Toledo.
(3) Using "DSC320/6200" produced by Seiko Instruments Inc., the specific heat of the thermally conductive sheet at 25°C was determined under a temperature rising condition of 10°C/min.
(4) The obtained thermal diffusivity was multiplied by the specific gravity and the specific heat to calculate the thermal conductivity of the thermally conductive sheet.

### (Evaluation standard)

The measured thermal conductivity was classified according to the following criteria, and the thermally conductive properties were evaluated.
"A+": 13 W/m·K or more
"A": 10 W/m·K or more and less than 13 W/m·K
"B": 8 W/m·K or more and less than 10 W/m·K
"C": 5 W/m·K or more and less than 8 W/m·K
"D": Less than 5 W/m·K

### <Adhesiveness evaluation>

An aluminum base substrate with a copper foil was prepared using the composition of each Example or each Comparative Example, and the following peel test was performed on the obtained aluminum base substrate with a copper foil to evaluate the adhesiveness of the thermally conductive sheet.

### (Preparation of aluminum base substrate with copper foil)

The composition having the formulation shown in Table 1 below of each Example and each Comparative Example was uniformly applied onto a release surface of the release-treated PET film by using an applicator, and left to stand at 120°C for 5 minutes to obtain a coating film.

Two PET films with such a coating film were prepared, and after attaching the two PET films with a coating film to coating film surfaces, the two PET films with a coating film were hot-pressed (treated at a hot plate temperature of 120°C and a pressure of 20 MPa for one minute) in the air to obtain a semi-cured film. The polyester films were peeled off from the obtained semi-cured film, sandwiched between an aluminum plate and a copper foil, and hot-pressed in the air (treated at a hot plate temperature of 180°C and a pressure of 10 MPa for 5 minutes, and then further treated at 180°C under normal pressure for 90 minutes) to obtain an aluminum base substrate with a copper foil.

### (Peel test)

A copper foil peel strength of the obtained aluminum base substrate with a copper foil was measured according to the method for measuring the peeling strength under normal conditions described in JIS C 6481.

### (Evaluation standard)

The measured peeling strength was classified according to the following criteria, and the adhesiveness was evaluated.
"A+": 5 N/cm or greater
"A": 4 N/cm or greater and less than 5 N/cm
"B": 3 N/cm or greater and less than 4 N/cm
"C": 1 N/cm or greater and less than 3 N/cm
"D": Less than 1 N/cm

### [Result]

Table 1 below shows the characteristics of the composition and the results of each evaluation test.

The "amount (%)" column indicates the content (% by mass) of each component with respect to the total solid content. Regarding the thermosetting compound A, a total content (% by mass) of the phenolic compound and the epoxy compound with respect to the total solid content is shown.

The "number of functional groups (mmol/g)" column of the "phenolic compound" indicates the phenolic hydroxyl group content (mmol/g) of the used phenolic compound.

In the "surface treatment method" column of "specific particles C or particles C", "treatment P1", "treatment P2", and "treatment P3" each mean that treatment described in the (plasma treatment 1), (plasma treatment 2), and (plasma treatment 3) is performed on the particles C to produce specific particles C, and the obtained specific particles C are used. In addition, in the same column, "UV treatment" means that treatment described in the (UV treatment) is performed on the particles C to produce specific particles C, and the obtained specific particles C are used. In addition, in the same column, a blank ("-") means that the particles C which have not been surface-treated are used (Comparative Examples 1, 2, and 4), or the surface-modified particles are used.

The "particles B ratio (%)" column shows a mass ratio of the content of the particles B to the total content of the boron nitride particles (particles B and specific particles C or particles C) contained in the composition.

**[Table 1] - the asterisk (*) indicates that the Example is a Reference Example.**

| Table 1 | Composition for forming thermally conductive material | | | | | | | | | | |
|---|---|---|---|---|---|---|---|---|---|---|---|
| | Thermosetting compound A | | | | | | Curing accelerator | Particles B | | | |
| | Phenolic compound | | | Epoxy compound | | Amount (%) | | Name | Particle diameter (µm) | Specific surface area (m²/g) | Amount (%) |
| | Kind | Molecular weight | Number of functional groups (mmol/g) | Kind | Epoxy equivalent | | | | | | |
| Example 1 | A-1 | 352 | 14.2 | B-1 | 111 | 24.0 | PPh₃ | HP-40 | 43.0 | 1.75 | 68.4 |
| | | | | | | | | MF-100 | | | |
| Example 2 | A-1 | 352 | 14.2 | B-1 | 111 | 24.0 | PPh₃ | HP-40 | 43.0 | 1.75 | 68.4 |
| | | | | | | | | MF-100 | | | |
| Example 3 | A-1 | 352 | 14.2 | B-1 | 111 | 24.0 | PPh₃ | HP-40 | 43.0 | 1.75 | 68.4 |
| | | | | | | | | MF-100 | | | |
| Example 4 | A-1 | 352 | 14.2 | B-1 | 111 | 24.0 | PPh₃ | HP-40 | 43.0 | 1.75 | 68.4 |
| | | | | | | | | MF-100 | | | |
| Example 5 | A-1 | 352 | 14.2 | B-1 | 111 | 24.0 | PPh₃ | HP-40 | 43.0 | 1.75 | 68.4 |
| | | | | | | | | MF-100 | | | |
| Example 6 | A-1 | 352 | 14.2 | B-1 | 111 | 24.0 | PPh₃ | HP-40 | 43.0 | 1.75 | 62.7 |
| | | | | | | | | MF-100 | | | |
| Example 7 | A-1 | 352 | 14.2 | B-1 | 111 | 24.0 | PPh₃ | HP-40 | 43.0 | 1.75 | 57.0 |
| | | | | | | | | MF-100 | | | |
| Example 8 | A-1 | 352 | 14.2 | B-1 | 111 | 24.0 | PPh₃ | HP-40 | 43.0 | 1.75 | 68.4 |
| | | | | | | | | MF-100 | | | |
| Example 9 | A-1 | 352 | 14.2 | B-1 | 111 | 24.0 | PPh₃ | HP-40 | 43.0 | 1.75 | 68.4 |
| | | | | | | | | MF-100 | | | |
| Example*10 | A-1 | 352 | 14.2 | B-1 | 111 | 24.0 | PPh₃ | HP-40 | 43.0 | 1.75 | 68.4 |
| | | | | | | | | MF-100 | | | |
| Example*11 | A-1 | 352 | 14.2 | B-1 | 111 | 24.0 | PPh₃ | HP-40 | 43.0 | 1.75 | 68.4 |
| | | | | | | | | MF-100 | | | |
| Example 12 | A-1 | 352 | 14.2 | B-1 | 111 | 24.0 | PPh₃ | PCTP30 | 27.0 | 1.40 | 68.4 |
| Example 13 | A-1 | 352 | 14.2 | B-1 | 111 | 24.0 | PPh₃ | PCTP30 | 27.0 | 1.40 | 68.4 |
| Example 14 | A-1 | 352 | 14.2 | B-1 | 111 | 24.0 | PPh₃ | PCTP30 | 27.0 | 1.40 | 68.4 |
| Example 15 | A-2 | 384 | 18.2 | B-1 | 111 | 24.0 | PPh₃ | HP-40 | 43.0 | 1.75 | 68.4 |
| | | | | | | | | MF-100 | | | |
| Example 16* | A-1 | 352 | 14.2 | B-2 | 177 | 24.0 | PPh₃ | HP-40 | 43.0 | 1.75 | 68.4 |
| | | | | | | | | MF-100 | | | |
| Example 17* | A-1 | 352 | 14.2 | B-3 | 156 | 24.0 | PPh₃ | HP-40 | 43.0 | 1.75 | 68.4 |
| | | | | | | | | MF-100 | | | |
| Example 18* | A-1 | 352 | 14.2 | B-4 | 139 | 24.0 | PPh₃ | HP-40 | 43.0 | 1.75 | 68.4 |
| | | | | | | | | MF-100 | | | |
| Example 19* | A-1 | 352 | 14.2 | B-5 | 196 | 24.0 | PPh₃ | HP-40 | 43.0 | 1.75 | 68.4 |
| | | | | | | | | MF-100 | | | |
| Example 20* | A-1 | 352 | 14.2 | B-6 | 366 | 24.0 | PPh₃ | HP-40 | 43.0 | 1.75 | 68.4 |
| | | | | | | | | MF-100 | | | |
| Example 21* | A-1 | 352 | 14.2 | B-7 | 300 | 24.0 | PPh₃ | HP-40 | 43.0 | 1.75 | 68.4 |
| | | | | | | | | MF-100 | | | |
| Example 22 | A-1 | 352 | 14.2 | B-1 | 111 | 24.0 | PPh₃ | HP-40 | 43.0 | 1.75 | 68.4 |
| | | | | | | | | MF-100 | | | |
| Example 23 | A-1 | 352 | 14.2 | B-1 | 111 | 24.0 | PPh₃ | HP-40 | 43.0 | 1.75 | 68.4 |
| | | | | | | | | MF-100 | | | |
| Example 24 | A-1 | 352 | 14.2 | B-1 | 111 | 24.0 | PPh₃ | XGP | 35.0 | 1.40 | 68.4 |
| Comparative Example 1 | A-1 | 352 | 14.2 | B-1 | 111 | 24.0 | PPh₃ | HP-40 | 43.0 | 1.75 | 76.0 |
| | | | | | | | | MF-100 | | | |
| Comparative Example 2 | A-1 | 352 | 14.2 | B-1 | 111 | 24.0 | PPh₃ | - | - | - | - |
| Comparative Example 3 | A-1 | 352 | 14.2 | B-1 | 111 | 24.0 | PPh₃ | - | - | - | - |
| Comparative Example 4 | A-1 | 352 | 14.2 | B-1 | 111 | 24.0 | PPh₃ | HP-40 | 43.0 | 1.75 | 68.4 |
| | | | | | | | | MF-100 | | | |
| Comparative Example 5 | A-1 | 352 | 14.2 | B-1 | 111 | 24.0 | PPh₃ | HP-40 | 43.0 | 1.75 | 68.4 |
| | | | | | | | | MF-100 | | | |

**[Table 2] - the asterisk (*) indicates that the Example is a Reference Example.**

| Table 1 (continued) | Composition for forming thermally conductive material (continued) | | | | | | | | Evaluation | |
|---|---|---|---|---|---|---|---|---|---|---|
| | Specific particles C or particles C | | | | | | | Particles B ratio (%) | Thermally conductive properties | Adhesiveness |
| | Name | Particle diameter (µm) | Specific surface area (m²/g) | Surface treatment method | Oxygen atom concentration on surface (atomic%) | Contact angle (°) | Amount (%) | | | |
| Example 1 | SP-2 | 3.0 | 34 | Treatment P1 | 2.7 | A+ | 7.6 | 90 | A+ | A+ |
| Example 2 | SP-3 | 4.0 | 25 | Treatment P1 | 2.7 | A | 7.6 | 90 | A+ | A |
| Example 3 | SP3-7 | 2.0 | 25 | Treatment P1 | 2.7 | A | 7.6 | 90 | A+ | A |
| Example 4 | MNB-010T | 0.8 | 13 | Treatment P1 | 2.7 | B | 7.6 | 90 | A+ | B |
| Example 5 | HGP | 5.0 | 9 | Treatment P1 | 2.7 | B | 7.6 | 90 | A+ | B |
| Example 6 | SP-2 | 3.0 | 34 | Treatment P1 | 2.7 | A+ | 12.3 | 84 | A | A+ |
| Example 7 | SP-2 | 3.0 | 34 | Treatment P1 | 2.7 | A+ | 19.0 | 75 | A | A+ |
| Example 8 | SP-2 | 3.0 | 34 | UV treatment | 2.7 | A+ | 7.6 | 90 | A+ | A+ |
| Example 9 | SP-3 | 4.0 | 25 | UV treatment | 2.7 | A | 7.6 | 90 | A+ | A |
| Example 10* | UHP-2 | 11.0 | 4 | Treatment P1 | 2.7 | C | 7.6 | 90 | A+ | C |
| Example 11_{*} | UHP-1K | 8.0 | 4 | Treatment P1 | 2.7 | C | 7.6 | 90 | A+ | C |
| Example 12 | SP-2 | 3.0 | 34 | Treatment P1 | 2.7 | A+ | 7.6 | 90 | B | A+ |
| Example 13 | SP-3 | 4.0 | 25 | Treatment P1 | 2.7 | A | 7.6 | 90 | B | A+ |
| Example 14 | MNB-010T | 0.8 | 13 | Treatment P1 | 2.7 | B | 7.6 | 90 | B | A+ |
| Example 15 | SP-2 | 3.0 | 34 | Treatment P1 | 2.7 | A+ | 7.6 | 90 | A+ | A+ |
| Example 16* | SP-2 | 3.0 | 34 | Treatment P1 | 2.7 | A+ | 7.6 | 90 | A+ | A |
| Example 17* | SP-2 | 3.0 | 34 | Treatment P1 | 2.7 | A+ | 7.6 | 90 | A+ | A |
| Example 18* | SP-2 | 3.0 | 34 | Treatment P1 | 2.7 | A+ | 7.6 | 90 | A+ | A |
| Example 19* | SP-2 | 3.0 | 34 | Treatment P1 | 2.7 | A+ | 7.6 | 90 | A+ | A |
| Example 20* | SP-2 | 3.0 | 34 | Treatment P1 | 2.7 | A+ | 7.6 | 90 | A+ | A |
| Example 21* | SP-2 | 3.0 | 34 | Treatment P1 | 2.7 | A+ | 7.6 | 90 | A+ | A |
| Example 22 | SP-2 | 3.0 | 34 | Treatment P2 | 1.6 | B | 7.6 | 90 | A+ | B |
| Example 23 | SP-2 | 3.0 | 34 | Treatment P3 | 2.2 | A | 7.6 | 90 | A+ | A |
| Example 24 | SP-2 | 3.0 | 34 | Treatment P1 | 2.7 | A+ | 7.6 | 90 | A | A+ |
| Comparative Example 1 | - | - | - | - | - | - | - | - | A | D |
| Comparative Example 2 | SP-2 | 3.0 | 34 | - | 1.1 | D | 76.0 | - | D | D |
| Comparative Example 3 | SP-2 | 3.0 | 34 | Treatment P1 | 2.7 | A+ | 76.0 | - | D | A+ |
| Comparative Example 4 | SP-2 | 3.0 | 34 | - | 1.1 | D | 7.6 | 90 | A | D |
| Comparative Example 5 | SP-2 (surface-modified) | 3.0 | 34 | - | 1.1 | D | 7.6 | 90 | A | D |

From the results shown in the table, it was confirmed that according to the composition according to the embodiment of the present invention, a thermally conductive material having excellent thermally conductive properties and adhesiveness can be obtained.

In a case where an average particle diameter of the particles B is 30.0 µm or more, it is confirmed that the thermally conductive material has more excellent thermally conductive properties (comparison between Examples 24 and Examples 12 to 14), and in a case where an average particle diameter of the particles B is 38.0 µm or more, it was confirmed that the thermally conductive material has further more excellent thermally conductive properties (comparison between Examples 1, 2, and 4 and Example 24).

In a case where an average particle diameter of the specific particles C is 5.0 µm or less, it was confirmed that the thermally conductive material has more excellent adhesiveness (comparison between Example 5 and Examples 10 and 11), in a case where an average particle diameter of the specific particles C is 1.0 to 4.5 µm, the thermally conductive material has further more excellent adhesiveness (comparison between Examples 1 to 3 and Examples 4 and 5), and in a case where an average particle diameter of the specific particles C is more than 2.0 µm and less than 4.0 µm, it was confirmed that the thermally conductive material has further more excellent adhesiveness (comparison of Examples 1 to 3).

In a case where the oxygen atom concentration on the surface of the specific particles C is 2.0 atomic% or more, it was confirmed that the thermally conductive material has more excellent adhesiveness (comparison between Examples 22 and Example 23), and in a case where the oxygen atom concentration on the surface of the specific particles C is 2.4 atomic% or more, it was confirmed the thermally conductive material has further more excellent adhesiveness (comparison between Example 1 and Example 23).

In a case where the content of the particles B contained in the composition is 65% by mass or more with respect to the total solid content of the composition, it was confirmed that the thermally conductive material has more excellent thermally conductive properties (comparison between Example 1 and Example 6).

In a case where the content of the specific particles C contained in the composition is 10% by mass or less with respect to the total solid content of the composition, it was confirmed that the thermally conductive material has more excellent thermally conductive properties (comparison between Example 1 and Example 6).

In addition, in a case where the content of the particles B with respect to the total content of the particles B and the specific particles C contained in the composition is 85% by mass or more, it was confirmed that the thermally conductive material has more excellent thermally conductive properties (comparison between Example 1 and Example 6).

In a case where the epoxy equivalent of the epoxy compound contained in the composition is 130 or less, it was confirmed that the thermally conductive material has more excellent adhesiveness (comparison between Example 1 and Example 18).

## Claims

1. A composition for forming a thermally conductive material comprising:
a thermosetting compound A,
wherein the thermosetting compound A includes an epoxy compound having an epoxy equivalent of 130 or less, measured as described in the description, and a phenolic compound, and wherein the content of the thermosetting compound A is 10% to 40% by mass with respect to the total solid content of the composition;
boron nitride particles B containing boron nitride and having an average particle diameter of 25.0 µm or more, measured as described in the description; and
boron nitride particles C containing boron nitride and having an average particle diameter of 5.0 µm or less, measured as described in the description;
wherein a content of the boron nitride particles B is 70% to 95% by mass with respect to a total content of the boron nitride particles B and the boron nitride particles C, and
wherein an oxygen atom concentration on a surface of the boron nitride particles C detected by X-ray photoelectron spectroscopic analysis, measured as described in the description, is 1.5 atomic% or more.

2. The composition for forming a thermally conductive material according to claim 1, wherein an average particle diameter of the boron nitride particles B is 30.0 µm or more.

3. The composition for forming a thermally conductive material according to any one of claims 1 to 2, wherein an average particle diameter of the boron nitride particles C is 1.0 to 4.5 µm.

4. A thermally conductive material which is obtained by curing the composition for forming a thermally conductive material according to any one of claims 1 to 3.

5. A thermally conductive sheet made of the thermally conductive material according to claim 4.

6. A device with a thermally conductive layer comprising:
a device; and
a thermally conductive layer including the thermally conductive sheet according to claim 5 arranged on the device.

## Patentansprüche

1. Zusammensetzung zum Bilden eines wärmeleitenden Materials, umfassend:
eine duroplastische Verbindung A,
wobei die duroplastische Verbindung A eine Epoxidverbindung mit einem Epoxidäquivalent von 130 oder weniger, gemessen wie in der Beschreibung beschrieben, und eine phenolische Verbindung enthält, und wobei der Gehalt der duroplastischen Verbindung A 10 Massen-% bis 40 Massen-% in Bezug auf den Gesamtfeststoffgehalt der Zusammensetzung beträgt;
Bornitridpartikel B, die Bornitrid enthalten und einen durchschnittlichen Partikeldurchmesser von 25,0 µm oder mehr aufweisen, der wie in der Beschreibung beschrieben gemessen wird; und
Bornitridpartikel C, die Bornitrid enthalten und einen durchschnittlichen Partikeldurchmesser von 5,0 µm oder weniger aufweisen, der wie in der Beschreibung beschrieben gemessen wird;
wobei ein Gehalt der Bornitridpartikel B 70 Massen-% bis 95 Massen-% in Bezug auf einen Gesamtgehalt der Bornitridpartikel B und der Bornitridpartikel C beträgt, und
wobei eine Sauerstoffatom-Konzentration auf einer Oberfläche der Bornitridpartikel C, die durch Röntgen-Photoelektronenspektroskopie-Analyse detektiert wird und wie in der Beschreibung beschrieben gemessen wird, 1,5 Atom-% oder mehr beträgt.

2. Zusammensetzung zum Bilden eines wärmeleitenden Materials nach Anspruch 1, wobei ein durchschnittlicher Partikeldurchmesser der Bornitridpartikel B 30,0 µm oder mehr beträgt.

3. Zusammensetzung zum Bilden eines wärmeleitenden Materials nach einem der Ansprüche 1 bis 2, wobei ein durchschnittlicher Partikeldurchmesser der Bornitridpartikel C 1,0 bis 4,5 µm beträgt.

4. Wärmeleitendes Material, das durch Härtung der Zusammensetzung zum Bilden eines wärmeleitenden Materials nach einem der Ansprüche 1 bis 3 erhalten wird.

5. Wärmeleitendes Blatt, das aus dem wärmeleitenden Material nach Anspruch 4 hergestellt ist.

6. Vorrichtung mit einer wärmeleitenden Schicht, umfassend:
eine Vorrichtung; und
eine wärmeleitende Schicht, die das wärmeleitende Blatt nach Anspruch 5, das an der Vorrichtung angeordnet ist, enthält.

## Revendications

1. Composition pour former un matériau thermoconducteur comprenant :
un composé thermodurcissable A,
dans laquelle le composé thermodurcissable A inclut un composé époxy ayant un équivalent époxy de 130 ou moins, mesuré comme décrit dans la description, et un composé phénolique, et dans laquelle la teneur du composé thermodurcissable A est de 10 % à 40 % en masse par rapport à la teneur solide totale de la composition ;
des particules de nitrure de bore B contenant du nitrure de bore et ayant un diamètre moyen de particules de 25,0 µm ou plus, mesuré comme décrit dans la description ; et
des particules de nitrure de bore C contenant du nitrure de bore et ayant un diamètre moyen de particules de 5,0 µm ou moins, mesuré comme décrit dans la description ;
dans laquelle une teneur des particules de nitrure de bore B est de 70 % à 95 % en masse par rapport à une teneur totale des particules de nitrure de bore B et des particules de nitrure de bore C, et
dans laquelle une concentration d'atomes d'oxygène sur une surface des particules de nitrure de bore C détectée par analyse spectroscopique de photoélectrons à rayons X, mesurée comme décrit dans la description, est de 1,5 % atomique ou plus.

2. Composition pour former un matériau thermoconducteur selon la revendication 1, dans laquelle un diamètre moyen de particules des particules de nitrure de bore B est de 30,0 µm ou plus.

3. Composition pour former un matériau thermoconducteur selon l'une quelconque des revendications 1 à 2, dans laquelle un diamètre moyen de particules des particules de nitrure de bore C est de 1,0 à 4,5 µm.

4. Matériau thermoconducteur qui est obtenu par durcissement de la composition pour former un matériau thermoconducteur selon l'une quelconque des revendications 1 à 3.

5. Feuille thermoconductrice constituée du matériau thermoconducteur selon la revendication 4.

6. Dispositif avec une couche thermoconductrice comprenant :
un dispositif ; et
une couche thermoconductrice incluant la feuille thermoconductrice selon la revendication 5 disposée sur le dispositif.
